# EUROPEAN PATENT APPLICATION

(11) **EP 4 651 642 A1**
(43) Date of publication of application: **19.11.2025**
(21) Application number: 23916156.5
(22) Date of filing: 20.11.2023
(51) Int. Cl.: H05K 3/00, B29C 65/02, H05K 3/20, H05K 3/38

(54) **CIRCUIT BOARD MANUFACTURING APPARATUS AND CIRCUIT BOARD MANUFACTURING METHOD**

(30) Priority: 10.01.2023 JP 2023001924; 27.07.2023 JP 2023122540
(71) Applicant: NHK Spring Co., Ltd., Kanagawa 236-0004 (JP)
(72) Inventor: YANO, Shinya, Yokohama-shi, Kanagawa 236-0004 (JP); KAWAKAMI, Takeshi, Yokohama-shi, Kanagawa 236-0004 (JP)
(74) Representative: DREISS Patentanwälte PartG mbB
(86) International application number: PCT/JP2023/041670
(87) International publication number: WO 2024/150539

(57) **Abstract**

A manufacturing device for a circuit board including a board, an insulation layer, and a circuit part fixed on the insulation layer. The circuit board manufacturing device includes a second pressing unit and a second stripping unit. The second pressing unit includes a lower mold including a reception jig on which the board is set and an upper mold that is disposed at an upper side with respect to the lower mold, and that, when the upper mold engages with the lower mold, presses the circuit part toward a side of the board through a urethane sheet including open cells or semi-open cells. The second stripping unit is provided on a path for conveying the board from the second pressing unit in a state in which the circuit part has been fixed on the insulation layer, and includes a gripper section that grips the urethane sheet and removes the urethane sheet from the board.

## Description

### Technical Field

The present disclosure relates to a circuit board manufacturing device and a circuit board manufacturing method.

### Background Art

A device disclosed in Japanese Patent Application Laid-Open (JP-A) No. 2003-48249 sticks a printed circuit board sheet having a surface formed with an irregular shaped profile and a cover sheet thereof or the like together by successively pressure bonding two or more sheets, at least one of the sheets being formed with irregularities, under a high vacuum. When sticking two sheets together using the device described in this document, firstly, the two sheets are disposed between upper and lower press-contact members and clamped between the upper and lower press-contact members. When this is performed, locations where these two sheets are compressed by the upper and lower press-contact members are sealed completely. Together with the two sheets being compression-fixed by the upper and lower press-contact members, an airtight compartment is formed when a lower face of a sliding frame body is closely adhered to an upper face of a cradle at high airtightness across the entire surface, with the airtight compartment being surrounded by an inner peripheral face of a frame body on the cradle and the lower face of a pressing block. This means that gas bubbles present between the two sheets can be removed by creating a vacuum inside this compartment. Furthermore, the two sheets are configured so as to be thermocompression bonded under a high vacuum by being compressed between the cradle and the pressing block while also being thermopressed.

### SUMMARY OF INVENTION

### Technical Problem

However, for a circuit board in which an insulation layer is fixed on a metal board through a pressure application process and also a circuit part is fixed on the insulation layer through a pressure application process, sometimes the circuit part is pressed toward the board setting through a sheet shaped member in the pressure application process, however the device described in JP-A No. 2003-48249 does not consider such a point.

In consideration of the above circumstances, a first object of the present disclosure is to provide a circuit board manufacturing device and a circuit board manufacturing method that enable a circuit part to be suppressed from being pressed excessively in a pressure application process, and a second object thereof is to provide a circuit board manufacturing device and a circuit board manufacturing method that enable a sheet shaped member to be removed after a pressure application process.

### Solution to Problem

A circuit board manufacturing device of a first aspect is a manufacturing device for a circuit board including a board that is formed from a metal material, an insulation layer that is formed in a sheet shape from an insulating material and that is fixed on the board, and a circuit part that is formed from an electroconductive material and that is fixed on the insulation layer. The circuit board manufacturing device includes a pressing unit including a lower mold including a board setting section on which the board is set and an upper mold that is disposed at an upper side with respect to the lower mold and that, when the upper mold engages with the lower mold, presses the circuit part toward a side of the board via a sheet shaped member including open cells or semi-open cells.

A circuit board manufacturing device of a second aspect is the circuit board manufacturing device of the first aspect, further including a stripping unit that is provided on a path for conveying the board from the pressing unit in a state in which the circuit part has been fixed on the insulation layer, and that includes a gripper section that grips the sheet shaped member and removes the sheet shaped member from the board.

A circuit board manufacturing device of a third aspect is the circuit board manufacturing device of the second aspect, wherein the stripping unit includes a push-up section that pushes up one portion of the sheet shaped member toward a side of the gripper section.

A circuit board manufacturing method of a fourth aspect employs the circuit board manufacturing device of the second aspect, and includes a setting process in which the board is set in the board setting section in a state in which the circuit part has been set on the insulation layer, and a pressure application process in which the circuit part is fixed to the insulation layer by engaging the upper mold with the lower mold and pressing the circuit part toward a side of the board via the sheet shaped member.

A circuit board manufacturing method of a fifth aspect is the circuit board manufacturing method of the fourth aspect, further including a removal process in which the upper mold is separated from the lower mold, and the board is removed from the board setting section in a state in which the circuit part has been fixed on the insulation layer, and a stripping process in which the sheet shaped member is gripped by the gripper section and removed from the board.

A circuit board manufacturing method of a sixth aspect is the circuit board manufacturing method of the fourth aspect, wherein the circuit board manufacturing device of claim 3 is employed, and in the stripping process, one portion of the sheet shaped member is pushed up toward the gripper section side by the push-up section.

The circuit board manufacturing device of the first aspect may, for example, employ the manufacturing method of the fourth aspect. In the manufacturing method of the fourth aspect, firstly, the board is set in the board setting section in a state in which the circuit part has been set on the insulation layer (setting process). Next, the circuit part is fixed to the insulation layer by engaging the upper mold with the lower mold and pressing the circuit part toward the board side through the sheet shaped member including open cells or semi-open cells (pressure application process). In this manner, the circuit board manufacturing device of the first aspect and the manufacturing method of the fourth aspect are able to suppress the circuit part from being pressed excessively in the pressure application process by pressing the circuit part toward the board side through the sheet shaped member including open cells or semi-open cells.

The circuit board manufacturing device of the second aspect may, for example, employ the manufacturing method of the fifth aspect. In the manufacturing method of the fifth aspect, after the pressure application process, the upper mold is separated from the lower mold, and the board is removed from the board setting section in a state in which the circuit part has been fixed on the insulation layer (removal process). Next, the sheet shaped member is gripped by the gripper section and removed from the board (stripping process). In this manner, the circuit board manufacturing device of the second aspect is able to remove the sheet shaped member after the pressure application process.

The circuit board manufacturing device of the third aspect may, for example, employ the manufacturing method of the sixth aspect. In the manufacturing method of the sixth aspect, in the stripping process, one portion of the sheet shaped member is pushed up toward the gripper section side by the push-up section. This accordingly enables the one portion of the sheet shaped member to be easily gripped by the gripper section.

The circuit board manufacturing method of the seventh aspect is the circuit board manufacturing method of the fourth aspect, wherein, in the pressure application process, adhesive overhanging from between the circuit part and the insulation layer is absorbed at the sheet shaped member.

The circuit board manufacturing method of the seventh aspect enables adhesive overhanging from between the circuit part and the insulation layer to be suppressed from remaining on the insulation layer due to adhesive overhanging from between the circuit part and the insulation layer being absorbed in the sheet shaped member.

The circuit board manufacturing method of the eighth aspect is the circuit board manufacturing method of the fourth aspect, further including a circuit part setting process that is performed prior to the pressure application process, and in which the circuit part is affixed to the sheet shaped member, and the circuit part, together with the sheet shaped member, is set on the insulation layer.

In the circuit board manufacturing method of the eighth aspect, in the circuit part setting process, the circuit part is stuck to the sheet shaped member, and the circuit part together with the sheet shaped member is set on the insulation layer. This thereby enables the sheet shaped member to be given the role of functioning as a member to perform positioning of the circuit part with respect to the insulation layer.

### Advantageous Effects

The circuit board manufacturing device and the circuit board manufacturing method according to the present disclosure exhibit the excellent advantageous effect of enabling a circuit part to be suppressed from being pressed excessively in a pressure application process. Moreover, the circuit board manufacturing device and the circuit board manufacturing method according to the present disclosure exhibit the excellent advantageous effect of enabling a sheet shaped member to be removed after a pressure application process.

### BRIEF DESCRIPTION OF DRAWINGS

Fig. 1 is a perspective view illustrating a circuit board.
Fig. 2 is a cross-section illustrating a circuit board.
Fig. 3 is a block diagram illustrating part of a circuit board manufacturing device.
Fig. 4 is a block diagram illustrating another part of a circuit board manufacturing device.
Fig. 5 is a perspective view illustrating an insulation layer formed on a PET film.
Fig. 6 is a perspective view to explain processes in an insulation layer cutting unit.
Fig. 7 is a perspective view illustrating a common conveyance jig and a positioning jig.
Fig. 8 is a perspective view to explain processes in a first setting unit, and illustrates a state in which a board has been set on a common conveyance jig.
Fig. 9 is a perspective view to explain processes in a first setting unit, and illustrates a process in which an insulation layer and the like are set on a board.
Fig. 10 is a side view to explain processes by a first preheating unit.
Fig. 11 is a side view illustrating a device employed in a first pressing unit.
Fig. 12 is a plan view illustrating a thermopress section conveyance unit.
Fig. 13 is a side view cross-section illustrating a thermopress section and the like.
Fig. 14 is a plan view illustrating a reception jig.
Fig. 15 is a side view cross-section illustrating processes in which an insulation layer that has been set on a board is pressed toward the board side.
Fig. 16 is a side view to explain a first insulation layer fixing process.
Fig. 17 is a side view to explain a first insulation layer fixing process.
Fig. 18 is a side view to explain a second insulation layer fixing process.
Fig. 19 is a side view to explain a third insulation layer fixing process and a fourth insulation layer fixing process.
Fig. 20 is a side view to explain a third insulation layer fixing process and a fourth insulation layer fixing process.
Fig. 21 is a side view to explain a fifth insulation layer fixing process.
Fig. 22 is a side view to explain a sixth insulation layer fixing process and a seventh insulation layer fixing process.
Fig. 23 is a side view to explain processes by a first demount unit.
Fig. 24 is a side view to explain processes by a first cooling unit.
Fig. 25 is a perspective view to explain processes by a first stripping unit.
Fig. 26 is a perspective view to explain processes by a first inspection unit.
Fig. 27 is a perspective view to explain processes by a circuit part sticking unit.
Fig. 28 is a perspective view to explain processes in a second setting unit, and illustrates a process in which circuit parts and the like are set on a board.
Fig. 29 is a side view cross-section illustrating processes in which circuit parts set on a board are pressed toward the board side.
Fig. 30 is a side view to explain processes by a second demount unit.
Fig. 31 is a side view to explain processes by a second cooling unit.
Fig. 32 is a perspective view to explain processes by a second stripping unit.
Fig. 33 is a perspective view to explain processes by a second inspection unit.
Fig. 34 is a side view to explain processes by a second stripping unit of a circuit board manufacturing device of a second exemplary embodiment.
Fig. 35 is a plan view to explain processes by a second stripping unit of a circuit board manufacturing device of a second exemplary embodiment, and illustrates a state in which an end portion of a urethane sheet has been gripped by a gripper section.
Fig. 36 is a side view to explain a second stripping unit of a circuit board manufacturing device of a second exemplary embodiment, and illustrates a state in which an end portion of a urethane sheet has been gripped by a gripper section.
Fig. 37 is a side view to explain processes by a second stripping unit of a circuit board manufacturing device of a second exemplary embodiment, and illustrates a state in which a gripper section has moved from the state illustrated in Fig. 36.
Fig. 38 is a side view to explain a second stripping unit of a circuit board manufacturing device of a second exemplary embodiment, and illustrates a state in which an end portion of a urethane sheet has been gripped by a gripper section.

### DESCRIPTION OF EMBODIMENTS

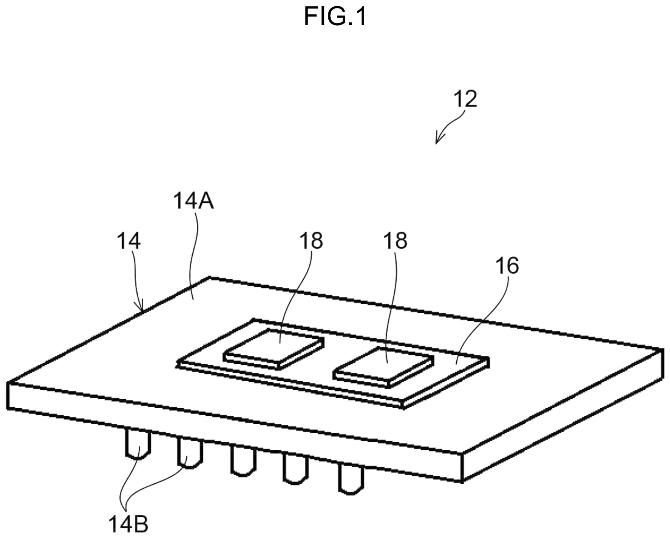

Firstly, description follows regarding a circuit board manufacturing device 10 and a circuit board manufacturing method according to an exemplary embodiment of the present disclosure, with reference to Fig. 1 to Fig. 33. Note that arrow UP in the drawings indicates an upward side of the circuit board manufacturing device 10. Firstly, an outline configuration of the circuit board 12 will be described, and next a circuit board manufacturing method will be described together with the configuration of the circuit board manufacturing device 10.

### Outline Configuration of Circuit Board 12

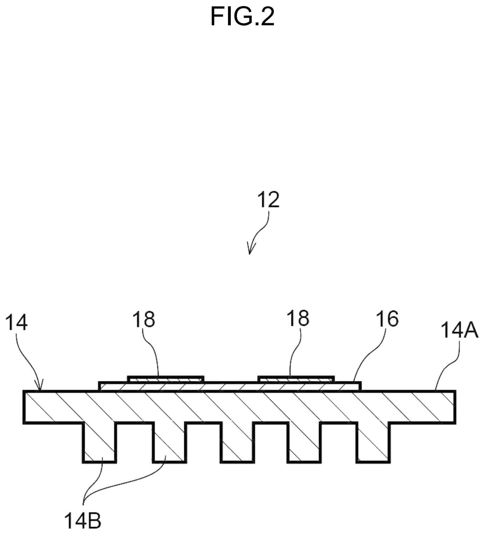

As illustrated in Fig. 1 and Fig. 2, the circuit board 12 includes a board 14, an insulation layer 16 fixed on the board 14, and circuit parts 18 fixed on the insulation layer 16.

The board 14 is formed from a metal material. The board 14 includes a plate shaped section 14A formed in a rectangular plate shape, and plural heat dissipation sections 14B that project out from the plate shaped section 14A. The insulation layer 16 and the circuit parts 18 are fixed, in a stacked state, to a thickness direction one-side face of the plate shaped section 14A. The plural heat dissipation sections 14B project out from a thickness direction other-side face of the plate shaped section 14A toward the opposite side to the plate shaped section 14A. The plural heat dissipation sections 14B are, as an example, formed in circular pillar shapes, and are arrayed regularly at a predetermined spacing from each other.

The insulation layer 16 is formed in a sheet shape from a material with electrical insulation properties. The insulation layer 16 secures insulation properties between the plate shaped section 14A of the board 14 and the circuit parts 18 by being interposed therebetween.

The circuit parts 18 are each formed in a rectangular plate shape from an electroconductive material. In the present exemplary embodiment, plural of the circuit parts 18 that have been formed so as to have a predetermined pattern are fixed on the insulation layer 16.

### Circuit Board Manufacturing Device 10 and Circuit Board Manufacturing Method

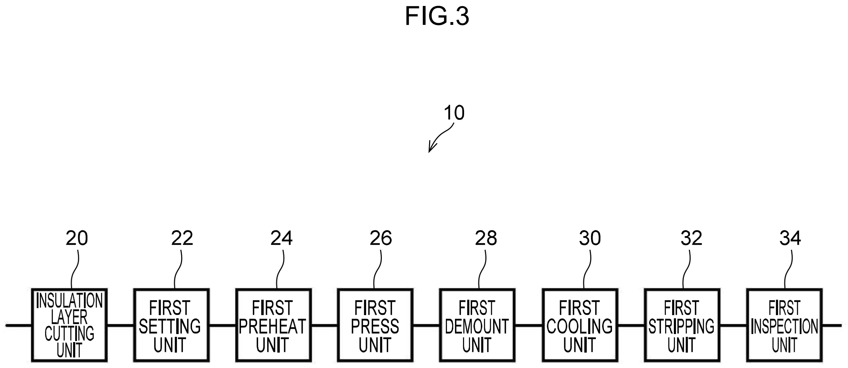

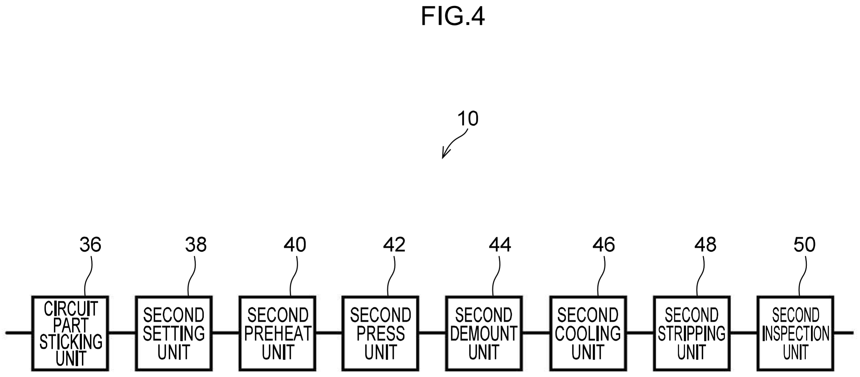

Fig. 3 and Fig. 4 are block diagrams schematically illustrating the circuit board manufacturing device 10 employed in the manufacture of the circuit board 12 (hereinafter simply referred to as "manufacturing device 10"). As illustrated in Fig. 3, the manufacturing device 10 includes an insulation layer cutting unit 20, a first setting unit 22, a first preheating unit 24, a first pressing unit 26, a first demount unit 28, a first cooling unit 30, a first stripping unit 32, and a first inspection unit 34. Moreover, as illustrated in Fig. 4, the manufacturing device 10 includes a circuit part sticking unit 36, a second setting unit 38, a second preheating unit 40, a second pressing unit 42, a second demount unit 44, a second cooling unit 46, a second stripping unit 48, and a second inspection unit 50.

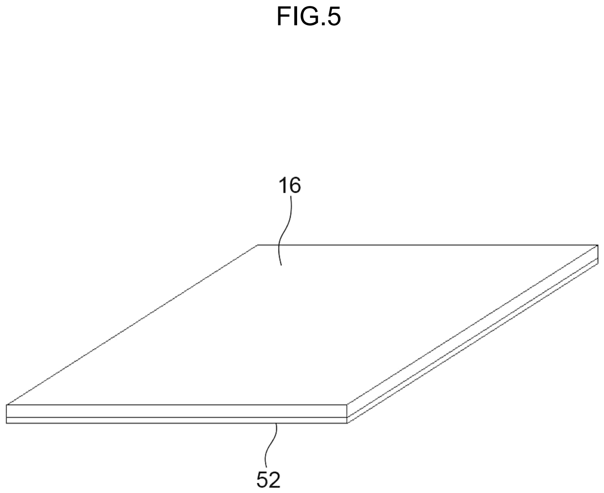

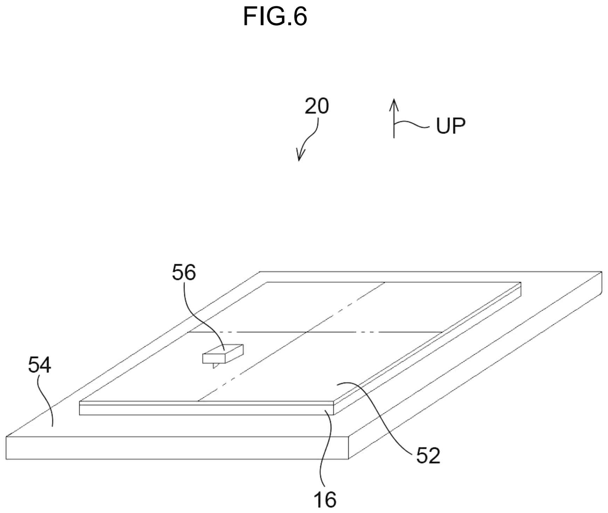

As illustrated in Fig. 3, Fig. 5, and Fig. 6, firstly, the insulation layer 16 is cut to a predetermined shape and dimensions in the insulation layer cutting unit 20. As illustrated in Fig. 5, the insulation layer 16 is formed in a sheet shape along a film 52 formed from polyethylene terephthalate (hereafter referred to as PET film 52). As illustrated in Fig. 6, the insulation layer cutting unit 20 includes a cutting jig 54 where the insulation layer 16 is placed together with the PET film 52, and a cutter 56 that cuts the insulation layer 16 placed on the cutting jig 54 together with the PET film 52. Then, in processes of the insulation layer cutting unit 20, firstly the insulation layer 16 is, together with the PET film 52, placed (set) on the cutting jig 54 in a state in which the insulation layer 16 faces downward with respect to the PET film 52. Next, the insulation layer 16 is, together with the PET film 52, cut to a predetermined shape and dimensions by moving the cutter 56 along a predetermined track on the cutting jig 54. Note that cutting locations are depicted in Fig. 6 by double-dashed broken lines. In the present exemplary embodiment, the insulation layer 16 is cut together with the PET film 52, and so distortion in the vicinity of cut portions of the insulation layer 16 is suppressed compared to cases in which the insulation layer 16 is cut as a single body. Note that all of the processes of the insulation layer cutting unit 20 may be performed automatically, or some or all of the processes of the insulation layer cutting unit 20 may be performed manually.

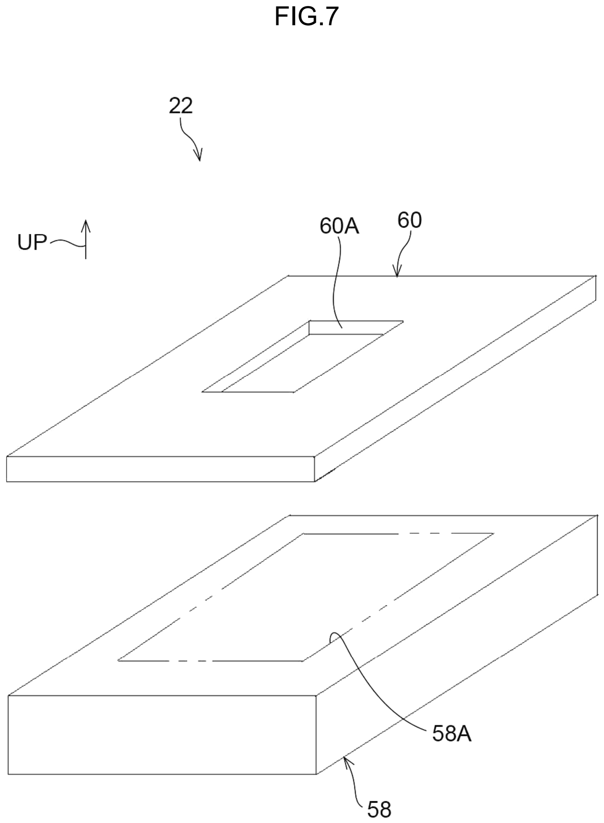

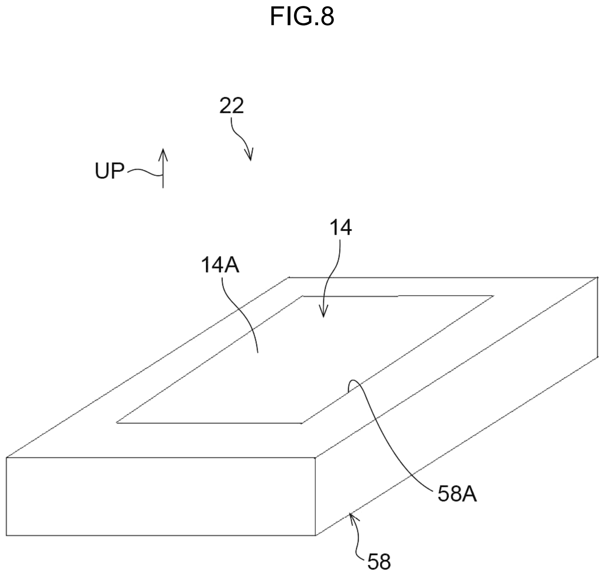

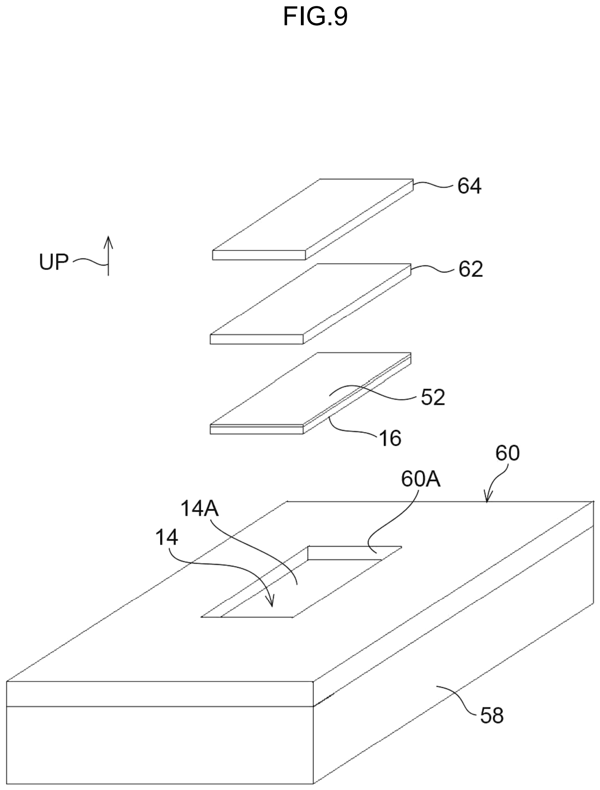

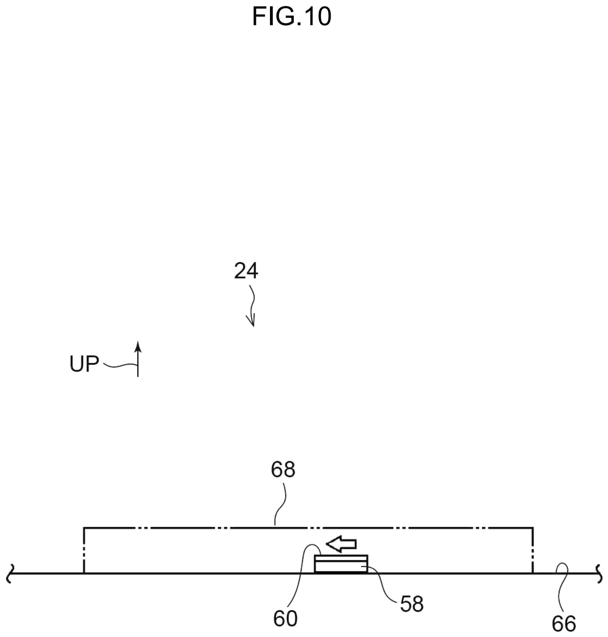

As illustrated in Fig. 3, Fig. 7, Fig. 8, and Fig. 9, in the first setting unit 22 the insulation layer 16 that has been cut to the predetermined shape and dimensions by the insulation layer cutting unit 20 is set on the board 14. As illustrated in Fig. 7, the first setting unit 22 employs a common conveyance jig 58 conveyed by a conveyance unit 66 (see Fig. 10), described later, and a positioning jig 60 that engages with the common conveyance jig 58. The common conveyance jig 58 includes a board setting section 58A where the board 14 is set in a fitted-in state. The positioning jig 60 is formed from a metal material similar to the common conveyance jig 58. A rectangular shaped positioning hole 60A is formed in the positioning jig 60 so as to pass through in an up-down direction. Then, movement of the positioning jig 60 in a horizontal direction (a direction orthogonal to the up-down direction) with respect to the common conveyance jig 58 is restricted by engaging the positioning jig 60 with the common conveyance jig 58 from above. Then, in processes of the first setting unit 22, firstly, as illustrated in Fig. 8, the board 14 is set on the board setting section 58A of the common conveyance jig 58 oriented with the plural heat dissipation sections 14B on the lower side thereof. Next, as illustrated in Fig. 9, the positioning jig 60 is engaged with the common conveyance jig 58 from above. In a state in which the positioning jig 60 is engaged with the common conveyance jig 58, a portion of the plate shaped section 14A of the board 14 to which the insulation layer 16 is to be fixed is exposed to the upper side through the positioning hole 60A. Next, an adhesive is coated onto the face of the insulation layer 16 that is on the opposite side to the PET film 52. Next, the insulation layer 16 is disposed inside the positioning hole 60A of the positioning jig 60 in a state in which the adhesive coated side of the insulation layer 16 is facing downward, and the insulation layer 16 is, together with the PET film 52, set on the plate shaped section 14A of the board 14. Next, a metal sheet 62 and piece of cardboard 64, which are set with shapes and dimensions corresponding to the shape and dimensions of the insulation layer 16 when viewed from above, are disposed inside the positioning hole 60A of the positioning jig 60, and the metal sheet 62 and the piece of cardboard 64 are set on the insulation layer 16 (on the PET film 52). Note that all of the processes of the first setting unit 22 may be performed automatically, or some or all of the processes of the first setting unit 22 may be performed manually.

As illustrated in Fig. 3 and Fig. 10, the board 14 and the insulation layer 16 are heated in the first preheating unit 24. As illustrated in Fig. 10, the first preheating unit 24 includes a heating oven 68 provided so as to surround the conveyance unit 66 that conveys the common conveyance jig 58. The temperature inside the heating oven 68 is maintained at a predetermined temperature. Then, in processes of the first preheating unit 24, the common conveyance jig 58 is moved inside the heating oven 68 by the common conveyance jig 58 being conveyed by the conveyance unit 66. The board 14 set on the common conveyance jig 58 and the insulation layer 16 and the like set on the board 14 are accordingly heated thereby.

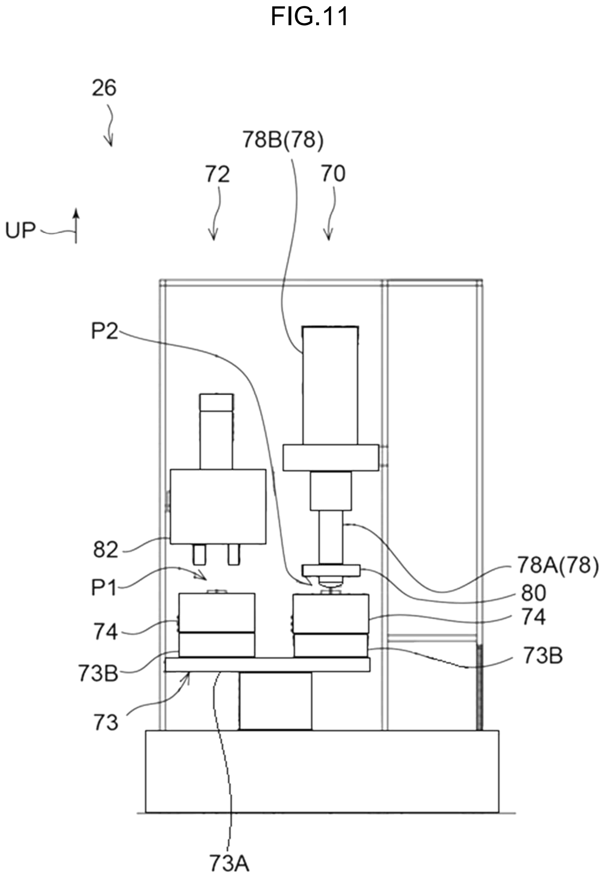

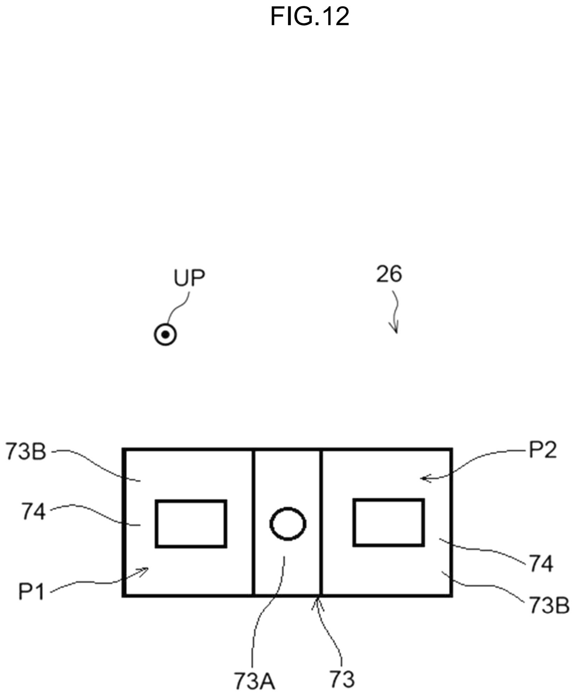

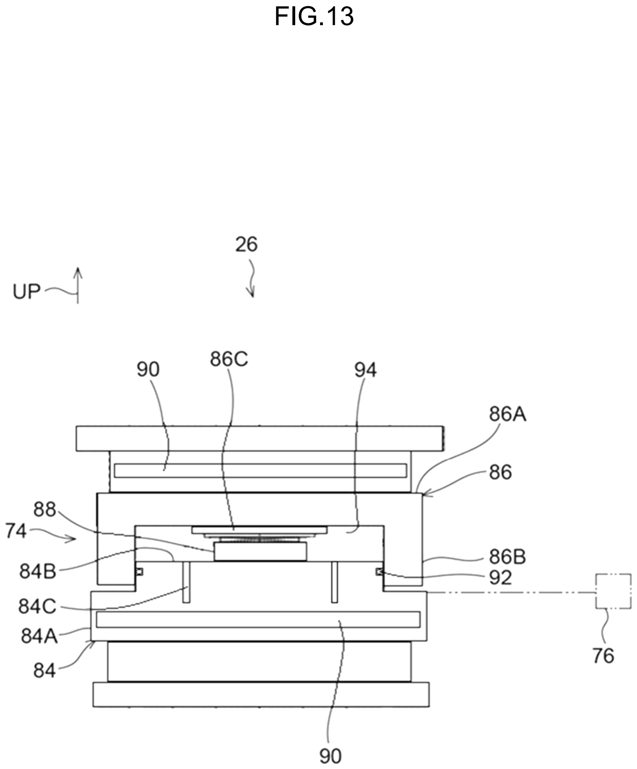

In the first pressing unit 26 as illustrated in Fig. 3 and Fig. 11 to Fig. 22, the insulation layer 16 set on the board 14 is pressed toward the board 14 side. As illustrated in Fig. 11 and Fig. 12, the first pressing unit 26 includes a pressing unit main body 70 including a mechanism to press an upper mold 86, described later, toward a lower mold 84 side, a setup unit 72 provided adjacent to the pressing unit main body 70, and a thermopress section conveyance unit 73 that moves a thermopress section 74, described later, and the like between the pressing unit main body 70 and the setup unit 72. Moreover, as illustrated in Fig. 13, the first pressing unit 26 includes two of the thermopress sections 74 for setting the board 14 and the like thereon, and an air suction unit 76.

As illustrated in Fig. 11, the pressing unit main body 70 includes a hydraulic cylinder 78, and an upper mold engaging section 80 supported by the hydraulic cylinder 78. The upper mold engaging section 80, described later, is configured so as to detachably engage with the upper mold 86. The upper mold engaging section 80 is configured so as to press the upper mold 86 downward by operating the hydraulic cylinder 78. Note that the hydraulic cylinder 78 of the present exemplary embodiment is configured by a high pressure cylinder 78A and a low pressure cylinder 78B stacked on each other in the up-down direction.

The setup unit 72 includes an upper mold raising-lowering section 82 that raises and lowers the upper mold 86, described later. The upper mold 86 is able to be raised or lowered with respect to the lower mold 84 by operating the upper mold raising-lowering section 82.

As illustrated in Fig. 11 and Fig. 12, the thermopress section conveyance unit 73 includes a rotation section 73A that is rotatable about an axial direction aligned with the up-down direction, and two lower mold engaging sections 73B fixed to upper portions of the rotation section 73A. The two thermopress sections 74, described later, are configured so as to respectively engage with the two lower mold engaging sections 73B. This results in a configuration in which, by rotating the rotation section 73A, one of the lower mold engaging sections 73B is moved from the pressing unit main body 70 to the setup unit 72, and the other of the lower mold engaging sections 73B is moved from the setup unit 72 toward the pressing unit main body 70. Thereby, the thermopress section 74 on the one lower mold engaging section 73B is moved from the pressing unit main body 70 to the setup unit 72, and the thermopress section 74 on the other lower mold engaging section 73B is moved from the setup unit 72 to the pressing unit main body 70. Note that a position on the lower mold engaging section 73B disposed in the setup unit 72 is referred to as being a "setup position P1", and a position on the lower mold engaging section 73B disposed in the pressing unit main body 70 is referred to as being a "pressure application position P2".

The two thermopress sections 74 are configured similarly to each other, as illustrated in Fig. 13. Note that only the thermopress section 74 disposed on the pressing unit main body 70 side is illustrated in Fig. 13. The thermopress section 74 includes the lower mold 84, the upper mold 86 that engages with the lower mold 84, and a reception jig 88 that serves as a board setting section fixed to the lower mold 84.

The lower mold 84 includes a lower plate section 84A fixed to the lower mold engaging section 73B, and a central protrusion 84B that projects upward from a horizontal direction central portion of the lower plate section 84A. The reception jig 88, described later, is fixed to the upper face of the central protrusion 84B. Moreover, a heater 90 for heating the lower mold 84 is provided in the lower plate section 84A. Furthermore, an O-ring 92 is mounted to the central protrusion 84B. A vacuum path 84C is formed in the lower plate section 84A and the central protrusion 84B, with one end side thereof opening onto the upper face of the central protrusion 84B, and the other end side thereof connected to the air suction unit 76, such as a vacuum pump or the like.

The upper mold 86 is disposed at the upper side with respect to the lower mold 84. The upper mold 86 includes an upper plate section 86A that detachably engages with the upper mold engaging section 80 and the upper mold raising-lowering section 82 (see Fig. 11), and a peripheral wall 86B that projects downward from horizontal direction end portions of the upper plate section 86A. The upper mold 86 is configured so as to engage with the lower mold 84 by moving the upper mold 86 toward the lower mold 84 side. In a state in which the upper mold 86 has engaged with the lower mold 84, the central protrusion 84B of the lower mold 84 is disposed inside the peripheral wall 86B of the upper mold 86. A sealed space 94 surrounding the reception jig 88 is thereby formed between the upper mold 86 and the lower mold 84. Note that in a state in which the upper mold 86 has engaged with the lower mold 84, a gap between the central protrusion 84B of the lower mold 84 and the peripheral wall 86B of the upper mold 86 is sealed by the O-ring 92. Moreover, the heater 90 for heating the upper mold 86 is provided in the upper plate section 86A. Furthermore, the upper mold 86 includes a pressure concentration section 86 that projects downward from a horizontal direction central portion of the upper plate section 86A.

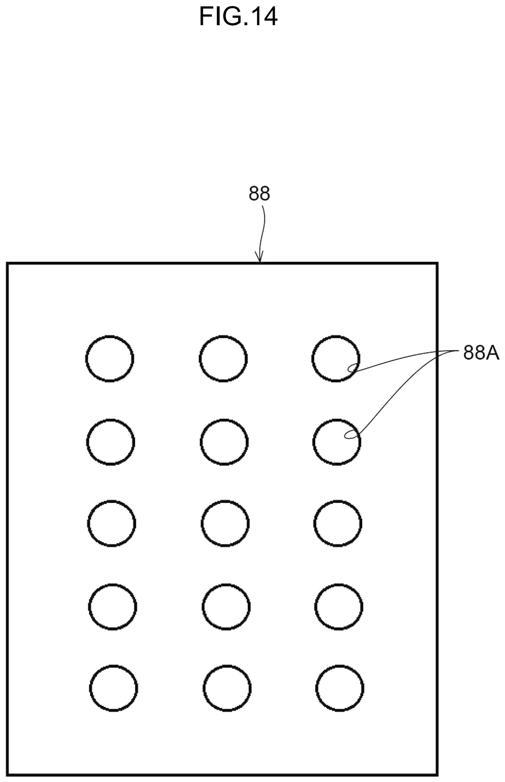

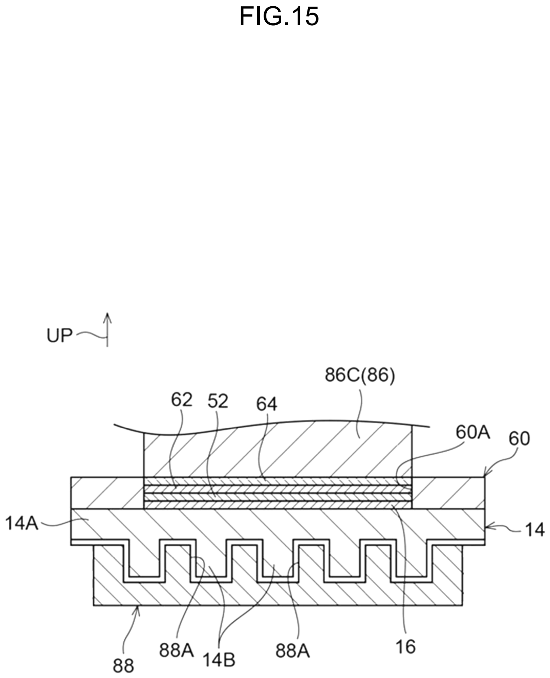

Fig. 14 illustrates the reception jig 88 in plan view, as viewed from above. The reception jig 88 is formed in a rectangular block shape. Moreover, there are plural insertion holes 88A opening upward formed in the reception jig 88. The plural insertion holes 88A are arrayed regularly at a predetermined spacing from each other so as to correspond to the plural heat dissipation sections 14B (see Fig. 1) of the board 14. Then, as illustrated in Fig. 15, the board 14 is set on the reception jig 88 in a state in which the plural heat dissipation sections 14B of the board 14 have been inserted into the plural insertion holes 88A. In the state in which the board 14 has been set on the reception jig 88, a lower face of the plate shaped section 14A (a face of the board 14 constituting bottom faces of the plural heat dissipation sections 14B) contacts the upper face of the reception jig 88.

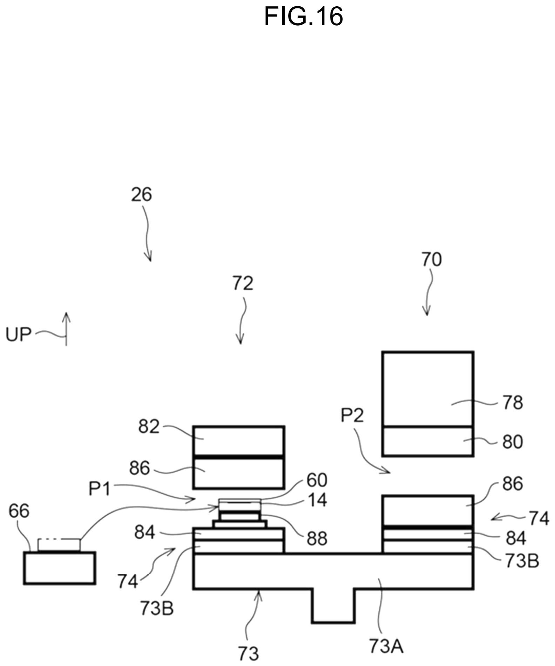

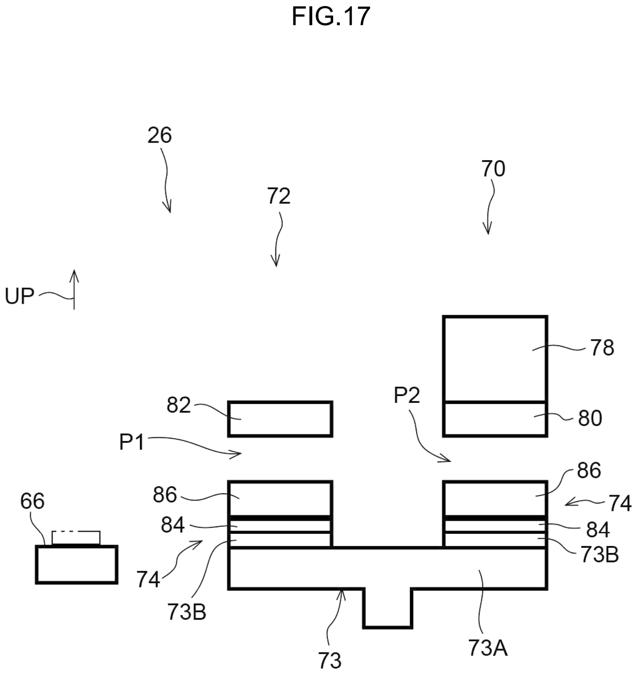

Then, as illustrated in Fig. 16, in processes of the first pressing unit 26, firstly the board 14 that has finished the processes by the first preheating unit 24 (has passed through the heating oven 68) is set on the thermopress section 74 disposed at the setup position P1. Then, by operation of a non-illustrated manipulator, the board 14 is moved, together with the positioning jig 60 and the like, and the board 14 is set in the reception jig 88 disposed at the setup position P1. Next, as illustrated in Fig. 17, the upper mold 86 is engaged with the lower mold 84 at the setup position P1 by operating the upper mold raising-lowering section 82 (first insulation layer fixing process). The upper mold 86 and the lower mold 84 are heated so as to attain a predetermined temperature by the heaters 90 mentioned above. Moreover, the air suction unit 76 is operated when the upper mold 86 is engaged with the lower mold 84 at the setup position P1, and air inside the sealed space 94 between the upper mold 86 and the lower mold 84 is suctioned out. Namely, a vacuum is created inside the sealed space 94 between the upper mold 86 and the lower mold 84.

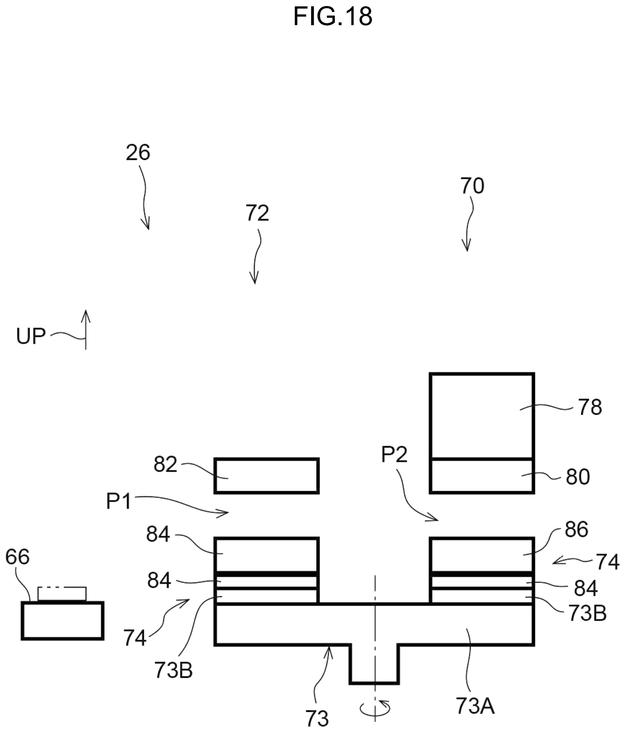

Next, as illustrated in Fig. 18, the thermopress section 74 disposed at the setup position P1 is moved to the pressure application position P2 side by rotating the rotation section 73A. When this occurs, the thermopress section 74 disposed at the pressure application position P2 is moved to the setup position P1 side (second insulation layer fixing process).

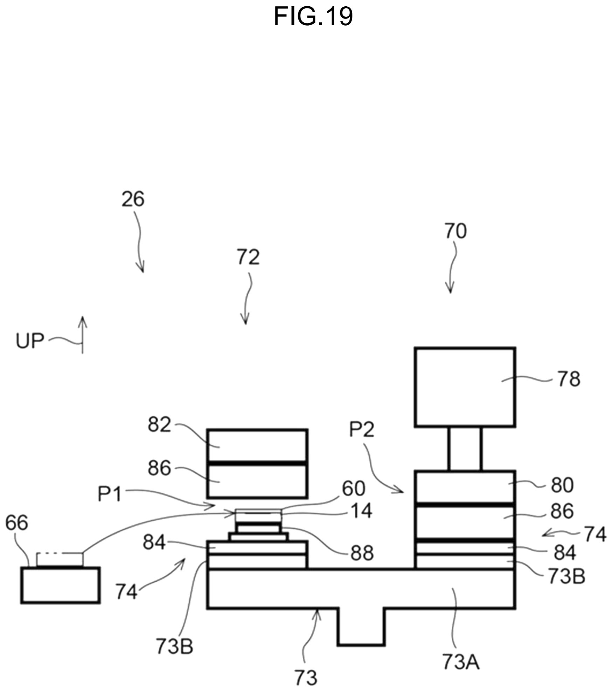

Next, as illustrated in Fig. 19, the upper mold engaging section 80 is engaged with the upper mold 86, and the upper mold 86 is pressed toward the lower mold 84 side at the pressure application position P2, thereby pressing the insulation layer 16 toward the board 14 side. The insulation layer 16 is thereby fixed to the board 14 (third insulation layer fixing process). Note that the third insulation layer fixing process is configured such that a state in which the insulation layer 16 is pressed toward the board 14 side is held for a predetermined period of time. Moreover, the upper mold 86 and the lower mold 84 are also heated by the heaters 90 in the third insulation layer fixing process, and also a vacuum is created inside the sealed space 94 between the upper mold 86 and the lower mold 84.

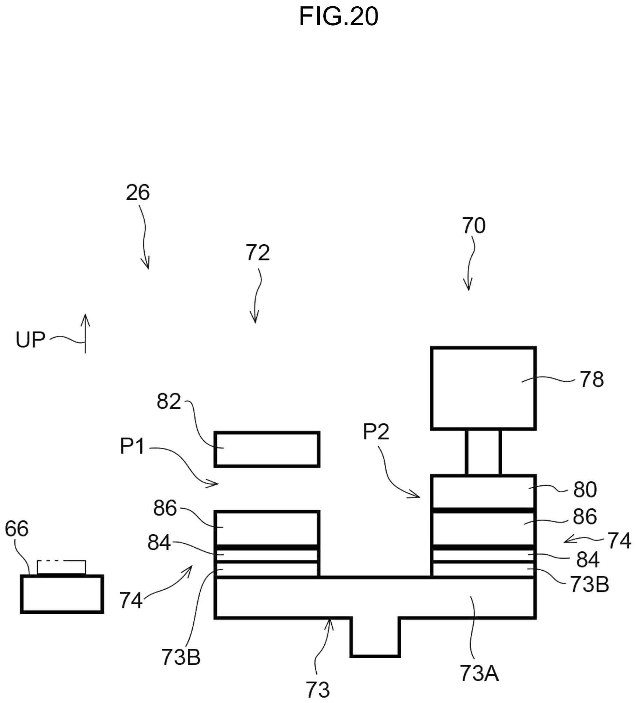

At the same time as (in parallel to) the third insulation layer fixing process, the board 14 that has finished the processes by the first preheating unit 24 (has passed through the heating oven 68) is set in the thermopress section 74 disposed at the setup position P1. Next, as illustrated in Fig. 20, by operating the upper mold raising-lowering section 82, the upper mold 86 is engaged with the lower mold 84 at the setup position P1 (fourth insulation layer fixing process). Moreover, when the upper mold 86 has been engaged with the lower mold 84 at the setup position P1, the air suction unit 76 is operated, and a vacuum is created inside the sealed space 94 between the upper mold 86 and the lower mold 84.

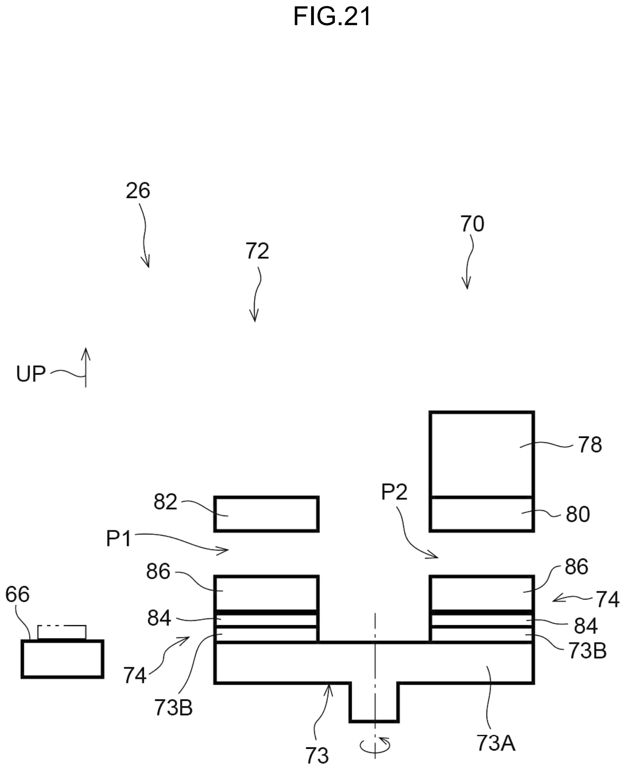

Next, as illustrated in Fig. 21, after engagement between the upper mold engaging section 80 and the upper mold 86 has been released, the thermopress section 74 that has finished the third insulation layer fixing process is moved from the pressure application position P2 to the setup position side by rotating the rotation section 73A. When this occurs, the thermopress section 74 that has finished the fourth insulation layer fixing process is moved from the setup position P1 to the pressure application position P2 side (fifth insulation layer fixing process).

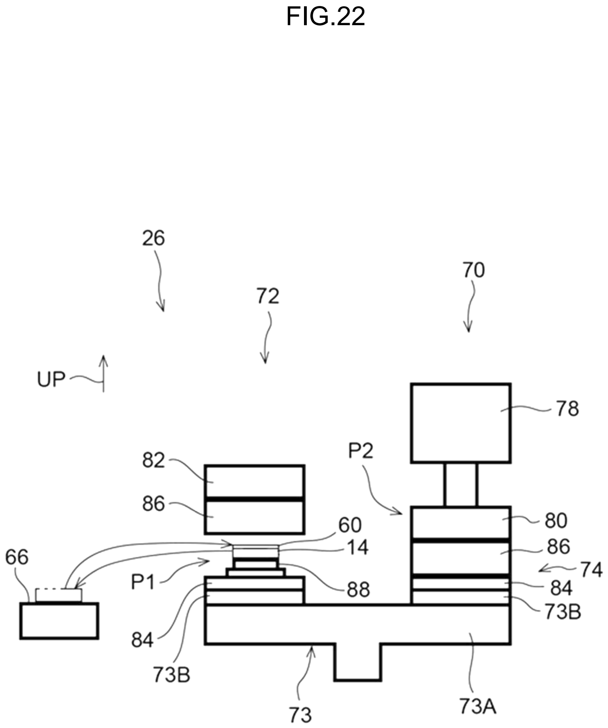

Next, as illustrated in Fig. 22, the insulation layer 16 is pressed toward the board 14 side by the upper mold engaging section 80 being engaged with the upper mold 86 and the upper mold 86 being pressed toward the lower mold 84 side at the pressure application position P2. The insulation layer 16 is thereby fixed to the board 14 (sixth insulation layer fixing process).

At the same time as (in parallel to) the sixth insulation layer fixing process, the board 14 with the insulation layer 16 affixed thereto is demounted (i.e. removed) from the thermopress section 74 disposed at the setup position P1. When this is performed, the board 14 is moved together with the positioning jig 60 and the like by operating a non-illustrated manipulator, and the board 14 is demounted from the reception jig 88 disposed at the setup position P1. The board 14 demounted from the reception jig 88 is returned, together with the positioning jig 60 and the like, to the common conveyance jig 58 on the conveyance unit 66. Next, a board 14 that has finished the processes by the first preheating unit 24 (has passed through the heating oven 68) is set in the thermopress section 74 disposed at the setup position P1 (seventh insulation layer fixing process). In this manner, by repeatedly performing the first insulation layer fixing process to the seventh insulation layer fixing process, the boards 14 and the like that have finished the processes by the first preheating unit 24 are introduced one after another into the first pressing unit 26. Moreover, the boards 14 and the like that have been introduced into the first pressing unit 26 are fed out one after another toward the next process.

In the first pressing unit 26 of the manufacturing device 10 of the present exemplary embodiment, the fourth insulation layer fixing process can be performed at the same time as third insulation layer fixing process. Moreover, the seventh insulation layer fixing process can be performed at the same time as the sixth insulation layer fixing process. This thereby enables a waiting time prior to passing through processes to fix the board 14 and the insulation layer 16 together to be suppressed from being prolonged. More specifically, a task to demount the board 14 affixed with the insulation layer 16 from the thermopress section 74 can be performed at the setup position P1 side while the insulation layer 16 is being pressed toward the board 14 side at the pressure application position P2. Moreover, a board 14 prior to being affixed with the insulation layer 16 can be set in the thermopress section 74 at the setup position P1 side while the insulation layer 16 is being pressed toward the board 14 side at the pressure application position P2. Furthermore, the board 14 and the like prior to being affixed with the insulation layer 16 can be heated by the heaters 90 respectively provided to the upper mold 86 and the lower mold 84 at the setup position P1 side while the insulation layer 16 is being pressed toward the board 14 side at the pressure application position P2. Moreover, a vacuum can be created inside the sealed space 94 formed between the upper mold 86 and the lower mold 84 at the setup position P1 side while the insulation layer 16 is being pressed toward the board 14 side at the pressure application position P2. The present exemplary embodiment is accordingly able to reduce time waiting while nothing is being performed prior to introducing the board 14 and the like that has finished the processes by the first preheating unit 24 into the first pressing unit 26.

Moreover, in the present exemplary embodiment, as illustrated in Fig. 15, a configuration is adopted in which the board 14 is set in the reception jig 88 in a state in which the plural heat dissipation sections 14B of the board 14 have been inserted into the plural insertion holes 88A of the reception jig 88. In the state in which the board 14 has been set in the reception jig 88, the lower face of the plate shaped section 14A (the face of the board 14 constituting the bottom faces of the plural heat dissipation sections 14B) contacts the upper face of the reception jig 88. This thereby enables the bottom faces of the plural heat dissipation sections 14B of the board 14 to be supported by the upper face of the reception jig 88. As a result thereof, pressure application can be performed to the fixing locations of the insulation layer 16 even when employing the metal board 14 including the plural heat dissipation sections 14B formed with protruding profiles.

Moreover, due to the pressure concentration section 86 of the upper mold 86 being inserted into the positioning hole 60A of the positioning jig 60, the present exemplary embodiment is configured such that portions on the plate shaped section 14A of the board 14 where the insulation layer 16 is placed are pressed in a concentrated manner. This thereby enables the portions where the insulation layer 16 is placed on the plate shaped section 14A of the board 14 to be pressed in a pinpoint manner.

Moreover, the present exemplary embodiment is configured such that the pressure concentration section 86 of the upper mold 86 presses the portion where the insulation layer 16 is placed on the plate shaped section 14A of the board 14 through the piece of cardboard 64 and the metal sheet 62. This thereby enables the portions where the insulation layer 16 is placed on the plate shaped section 14A of the board 14 to be pressed uniformly, and also enables voids (gas bubbles) to be suppressed from being generated in the insulation layer 16. Moreover, by providing the metal sheet 62 between the piece of cardboard 64 and the insulation layer 16 (the PET film 52), irregularities in the piece of cardboard 64 can be prevented from being transferred to the insulation layer 16.

Moreover, in the present exemplary embodiment, air inside the sealed space 94 formed between the upper mold 86 and the lower mold 84 can be suctioned out by the air suction unit 76. This thereby enables a vacuum to be created at the periphery of the fixing locations of the insulation layer 16 faster than configurations in which the air in a space outside the lower mold 84 and the upper mold 86 is also suctioned out in order to suction out the air from inside the sealed space 94 formed between the upper mold 86 and the lower mold 84.

Moreover, in the present exemplary embodiment, the board 14 and the like is heated in the processes of the first preheating unit 24. This thereby enables the time for heating the board 14 and the like in the processes of the first pressing unit 26 to be shortened.

Note that all the above-described processes of the first pressing unit 26 may be performed automatically, or some of the processes of the first pressing unit 26 may be performed manually.

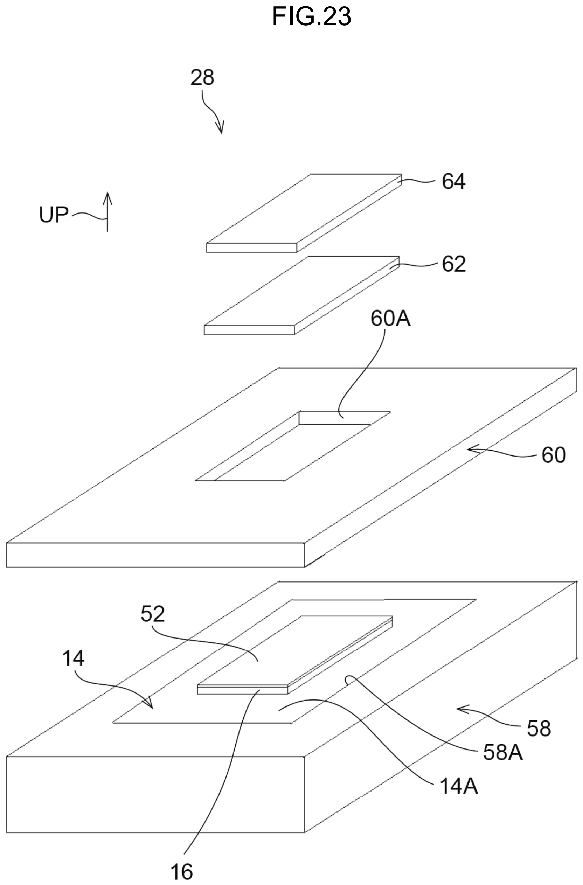

As illustrated in Fig. 3 and Fig. 23, in the first demount unit 28, the positioning jig 60 is demounted from the common conveyance jig 58 that has been sent in from the first pressing unit 26. Moreover, in the first demount unit 28, the metal sheet 62 and the piece of cardboard 64 that have been set on the insulation layer 16 are demounted. Note that all the processes of the first demount unit 28 may be performed automatically, or some or all of the processes of the first demount unit 28 may be performed manually.

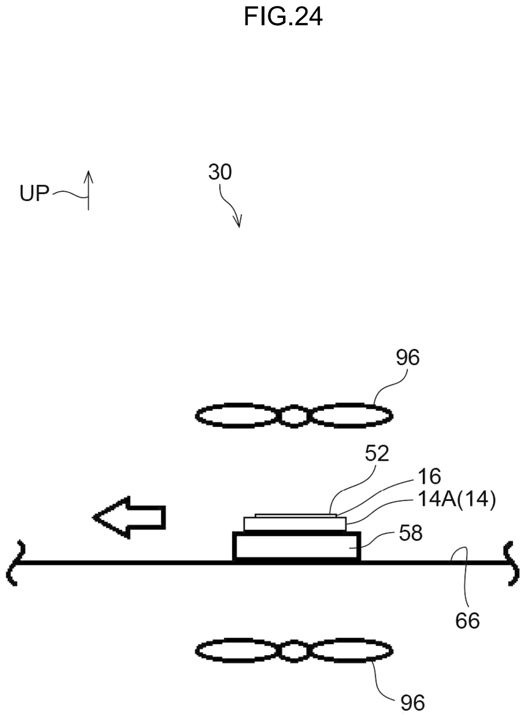

As illustrated in Fig. 3 and Fig. 24, the board 14 and the insulation layer 16 are cooled in the first cooling unit 30. As illustrated in Fig. 24, the first cooling unit 30 includes fans 96 respectively provided at an upper side and a lower side of the conveyance unit 66 that conveys the common conveyance jig 58. By the processes of the first cooling unit 30, the common conveyance jig 58 is conveyed by the conveyance unit 66, and the common conveyance jig 58 passes between the upper and lower fans 96. The board 14 set on the common conveyance jig 58 and the insulation layer 16 that has been fixed onto the board 14 are cooled thereby.

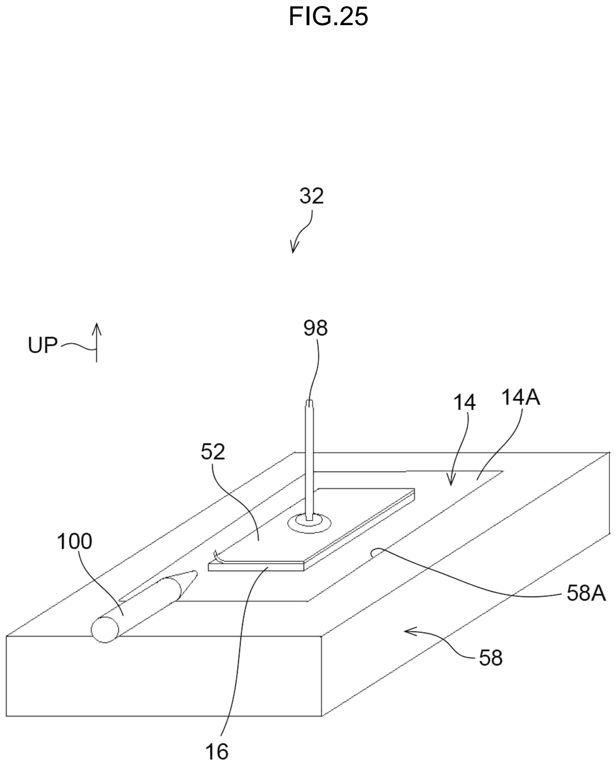

As illustrated in Fig. 3 and Fig. 25, the PET film 52 is removed from the insulation layer 16 in the first stripping unit 32. As illustrated in Fig. 25, the first stripping unit 32 includes a suction part 98 that suctions the PET film 52, and a nozzle 100 that ejects compressed air between the PET film 52 and the insulation layer 16. Then, in the processes of the first stripping unit 32, firstly a horizontal direction central portion of the PET film 52 is suctioned by the suction part 98. Next, the suction part 98 is moved while continuing to eject compressed air from the nozzle 100 to in between the PET film 52 and the insulation layer 16. The PET film 52 is thereby stripped from the insulation layer 16. Note that the PET film 52 that has been stripped from the insulation layer 16 is carried by the suction part 98 and thrown away into a specific container. Note that all the processes of the first stripping unit 32 may be performed automatically, or some or all of the processes of the first stripping unit 32 may be performed manually.

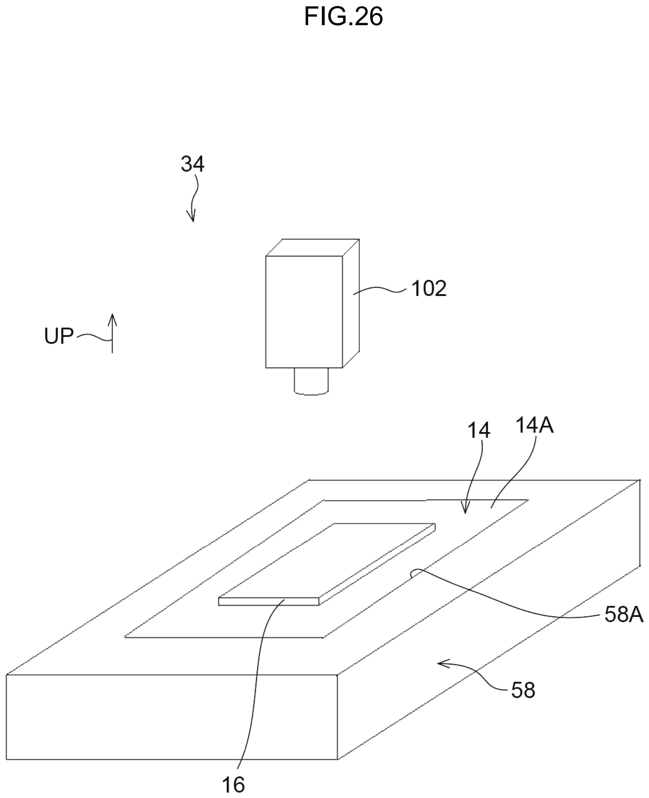

As illustrated in Fig. 3 and Fig. 26, inspection is performed in the first inspection unit 34 as to whether or not the insulation layer 16 is fixed to a predetermined position on the board 14. As illustrated in Fig. 26, the first inspection unit 34 includes a camera 102. Then, in the processes of the first inspection unit 34, inspection is performed as to whether or not the insulation layer 16 is fixed to a predetermined position on the board 14 by comparing inspection data with an image of the board 14 and the insulation layer 16 captured by the camera 102. In cases in which the output inspection result is that the insulation layer 16 is fixed to the predetermined position on the board 14, the board 14 affixed with the insulation layer 16 is conveyed toward the next process. On the other hand, in cases in which the output inspection result is that the insulation layer 16 is not fixed to the predetermined position on the board 14, the board 14 affixed with the insulation layer 16 is discarded without going toward the next process. Note that all the processes of the first inspection unit 34 may be performed automatically, or some or all of the processes of the first inspection unit 34 may be performed manually.

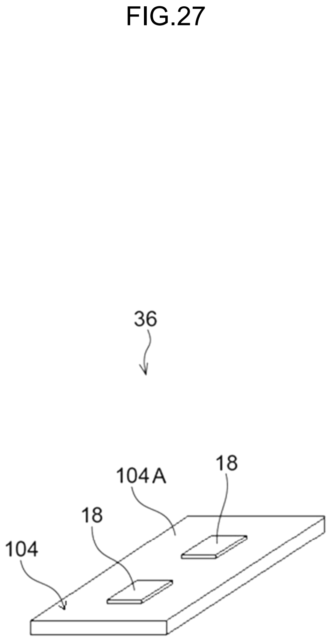

As illustrated in Fig. 4 and Fig. 27, the circuit parts 18 are stuck to a urethane sheet 104 by the circuit part sticking unit 36. As illustrated in Fig. 27, the shape and dimensions of the urethane sheet 104 when viewed along the thickness direction are set to a shape and dimensions corresponding to the insulation layer 16. Moreover, a thickness direction of the urethane sheet 104 is a uniform dimension at each portion of the urethane sheet 104 in a state prior to passing through a pressure application process, described later. An adhesive layer 104A capable of sticking the circuit parts 18 is formed to a one-side face of the urethane sheet 104. Then, in the processes of the circuit part sticking unit 36, the circuit parts 18 are stuck to predetermined positions on the face of the urethane sheet 104 formed with the adhesive layer 104A (circuit part setting process). The circuit parts 18 are thereby fixed to the urethane sheet 104. Note that all the processes of the circuit part sticking unit 36 may be performed automatically, or some or all of the processes of the circuit part sticking unit 36 may be performed manually. The urethane sheet 104 employed here is a low resilience sheet formed from a polyurethane foam that includes microcells (open cells or semi-open cells) and, for example, is a sheet having a density of 80 kg/m³ and a thickness dimension of 5 mm. The urethane sheet 104 compression-deforms when the urethane sheet 104 is applied with pressure in its thickness direction. Moreover, the urethane sheet 104 slowly rebounds when pressure application is stopped. Note that a semi-open cell means a structure including both closed cells and open cells. Moreover, a closed cell means a structure formed in a state in which each individual cell (bubble) is not connected to other cells during foaming of the raw material. Moreover, an open cell is a structure formed in a state in which an individual cell (bubble) is connected to other cells during foaming of the raw material. Namely, a urethane sheet 104 including semi-open cells is a urethane sheet 104 that includes both holes that are present independently of other holes, and holes that are joined to each other, inside the sheet. A urethane sheet 104 including open cells is a urethane sheet 104 that includes holes that are joined to each other inside the sheet. Note that, in both closed cells and open cells, cells that are present at the surface of the urethane sheet may have a structure that is open to the external environment.

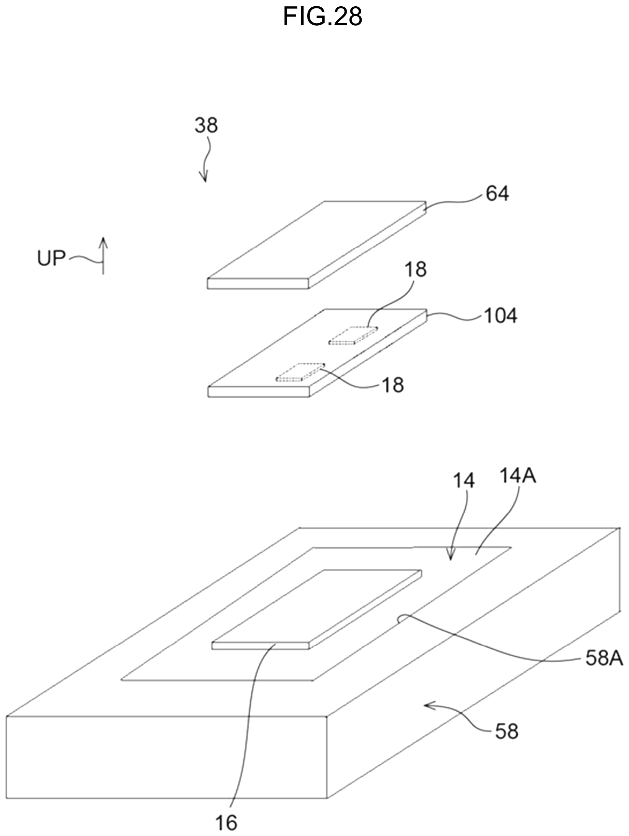

As illustrated in Fig. 4 and Fig. 28, in the second setting unit 38, the circuit parts 18 fixed to the urethane sheet 104 are, together with the urethane sheet 104, set on the insulation layer 16 which has been fixed to the board 14 (circuit part setting process). Adopting such an approach enables the urethane sheet 104 to be given the role of functioning as a member to perform positioning of the circuit parts 18 with respect to the insulation layer 16.

In the processes of the second setting unit 38, a face of the circuit parts 18 on the opposite side to the urethane sheet 104 is coated in an adhesive. Alternatively, adhesive is coated onto portions of the insulation layer 16 where the circuit parts 18 are to be fixed. Next, the circuit parts 18 are, together with the urethane sheet 104, set on the insulation layer 16 in a state in which the faces of the circuit parts 18 on the opposite side to the urethane sheet 104 are facing downward. Next, the piece of cardboard 64 is set on the urethane sheet 104. Note that all the processes of the second setting unit 38 may be performed automatically, or some or all of the processes of the second setting unit 38 may be performed manually.

As illustrated in Fig. 4, the board 14, the insulation layer 16, and the circuit parts 18 are heated by the second preheating unit 40. Note that the processes of the second preheating unit 40 are similar processes to the processes of the first preheating unit 24. Namely, in the processes of the second preheating unit 40, the common conveyance jig 58 is moved inside the heating oven 68 by the common conveyance jig 58 being conveyed by the conveyance unit 66 (see Fig. 10). The board 14, the insulation layer 16, and the circuit parts 18 and the like that have been set on the common conveyance jig 58 are thereby heated.

As illustrated in Fig. 4, the circuit parts 18 that have been set on the insulation layer 16 are pressed toward the board 14 side in the second pressing unit 42 serving as a pressing unit. In the processes in the second pressing unit 42, similarly to in the processes in the first pressing unit 26, a pressing unit main body 70, a setup unit 72, a thermopress section conveyance unit 73, two thermopress sections 74, and an air suction unit 76 are employed as illustrated in Fig. 11 to Fig. 14. Each of the processes in the second pressing unit 42 is a process similar to the respective process in the first pressing unit 26. This means that description of each of the processes in the second pressing unit 42 will be performed using the same diagrams to the diagrams employed when describing each of the processes in the first pressing unit 26.

As illustrated in Fig. 16, in the processes in the second pressing unit 42, firstly, a board 14 that has finished the processes by the second preheating unit 40 (passed through the heating oven 68) is set in the thermopress section 74 disposed at the setup position P1 (setting process). When doing so, the board 14 is set on the reception jig 88 disposed at the setup position P1 by operating a non-illustrated manipulator. Next, as illustrated in Fig. 17, the upper mold 86 is engaged with the lower mold 84 at the setup position P1 by operating the upper mold raising-lowering section 82 (first circuit part fixing process). The upper mold 86 and the lower mold 84 are heated so as to attain a predetermined temperature by the heaters 90 described above. Moreover, when the upper mold 86 has been engaged with the lower mold 84 at the setup position P1, the air suction unit 76 is operated, and air is suctioned out from inside the sealed space 94 between the upper mold 86 and the lower mold 84. Namely, a vacuum is created inside the sealed space 94 between the upper mold 86 and the lower mold 84.

Next, as illustrated in Fig. 18, the thermopress section 74 disposed at the setup position P1 is moved to the pressure application position P2 side by rotating the rotation section 73A. When doing so, the thermopress section 74 disposed at the pressure application position P2 is moved to the setup position P1 side (second circuit part fixing process).

Next, as illustrated in Fig. 19, the upper mold engaging section 80 is engaged with the upper mold 86, and the circuit parts 18 that have been set on the insulation layer 16 are pressed toward the board 14 side by pressing the upper mold 86 toward the lower mold 84 side at the pressure application position P2. The circuit parts 18 are thereby fixed to the insulation layer 16 (pressure application process, third circuit part fixing process). Note that the third circuit part fixing process is configured such that a state in which the circuit parts 18 are pressed toward the board 14 side is held in for a predetermined period of time. Moreover, the third circuit part fixing process is configured such that the circuit parts 18 are pressed toward the board 14 side with a lower pressure than the pressure applied in the third insulation layer fixing process described above. In order to achieve this, for example, the high pressure cylinder 78A may be operated alone in the third insulation layer fixing process, and the low pressure cylinder 78B may be operated alone in the third circuit part fixing process. Moreover, the third circuit part fixing process is also configured such that the upper mold 86 and the lower mold 84 are heated by the heaters 90, and a vacuum is created inside the sealed space 94 between the upper mold 86 and the lower mold 84.

At the same time as (in parallel to) the third circuit part fixing process, the board 14 that has finished the processes by the second preheating unit 40 (has passed through the heating oven 68) is set in the thermopress section 74 disposed at the setup position P1 (setting process). Next, as illustrated in Fig. 20, the upper mold 86 is engaged with the lower mold 84 at the setup position P1 by operating the upper mold raising-lowering section 82 (fourth circuit part fixing process). Moreover, when the upper mold 86 has been engaged with the lower mold 84 at the setup position P1, the air suction unit 76 is operated, and a vacuum is created inside the sealed space 94 formed between the upper mold 86 and the lower mold 84.

Next, as illustrated in Fig. 21, after the engagement between the upper mold engaging section 80 and the upper mold 86 has been released, the thermopress section 74 that has finished the third circuit part fixing process is moved from the pressure application position P2 to the setup position side by rotating the rotation section 73A. When doing so, the thermopress section 74 that has finished the fourth circuit part fixing process is moved from the setup position P1 to the pressure application position P2 side (fifth circuit part fixing process).

Next, as illustrated in Fig. 22, the upper mold engaging section 80 is engaged with the upper mold 86, and the circuit parts 18 that have been set on the insulation layer 16 are pressed toward the board 14 side by pressing the upper mold 86 toward the lower mold 84 side at the pressure application position P2. The circuit parts 18 are thereby fixed to the insulation layer 16 (pressure application process, sixth circuit part fixing process).

At the same time as (in parallel to) the sixth circuit part fixing process, the board 14 in a state in which the circuit parts 18 have been fixed on the insulation layer 16 is demounted (i.e. removed) from the thermopress section 74 disposed at the setup position P1 (removal process). When doing so, the board 14 is demounted from the reception jig 88 disposed at the setup position P1 by operating a non-illustrated manipulator. The board 14 demounted from the reception jig 88 is returned again to the common conveyance jig 58 on the conveyance unit 66. Next, the board 14 that has finished the processes by the second preheating unit 40 (has passed through the heating oven 68) is set in the thermopress section 74 disposed at the setup position P1 (setting process, seventh circuit part fixing process). In this manner, by repeatedly performing the first circuit part fixing process to the seventh circuit part fixing process, the boards 14 and the like that have finished the processes by the second preheating unit 40 are introduced one after another into the second pressing unit 42. Moreover, the boards 14 and the like that have been introduced into the second pressing unit 42 are fed out one after another toward the next process.

In the second pressing unit 42 of the manufacturing device 10 of the present exemplary embodiment, the fourth circuit part fixing process can be performed at the same time as the third circuit part fixing process. Moreover, the seventh circuit part fixing process can be performed at the same time as the sixth circuit part fixing process. This thereby enables the waiting time prior to passing through processes to fix the circuit parts 18 and the insulation layer 16 to be suppressed from being prolonged. More specifically, a task to demount the board 14 having the circuit parts 18 fixed on the insulation layer 16 from the thermopress section 74 can be performed at the setup position P1 side while the circuit parts 18 are being pressed toward the board 14 side at the pressure application position P2. Moreover, the board 14 that has the circuit parts 18 set on the insulation layer 16 can be set in the thermopress section 74 at the setup position P1 side while the circuit parts 18 are being pressed toward the board 14 side at the pressure application position P2. Furthermore, the board 14 and the like having the circuit parts 18 set on the insulation layer 16 can be heated by the heaters 90 respectively provided to the upper mold 86 and the lower mold 84 at the setup position P1 side while the circuit parts 18 are being pressed toward the board 14 side at the pressure application position P2. Moreover, a vacuum can be created inside the sealed space 94 formed between the upper mold 86 and the lower mold 84 at the setup position P1 side while the circuit parts 18 are being pressed toward the board 14 side at the pressure application position P2. In this manner, the present exemplary embodiment is able to shorten the time waiting while nothing is being performed prior to introducing the board 14 and the like that have finished the processes by the second preheating unit 40 into the second pressing unit 42.

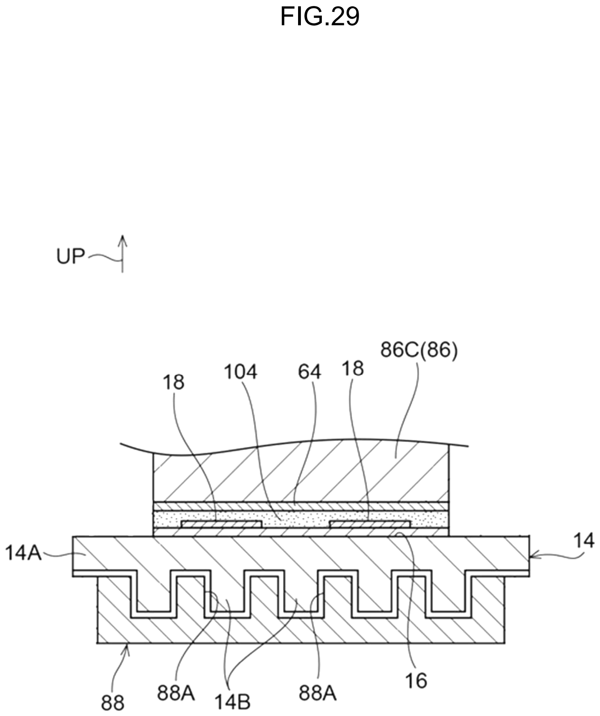

Moreover, the present exemplary embodiment is configured such that, as illustrated in Fig. 29, the board 14 is set in the reception jig 88 in a state in which the plural heat dissipation sections 14B of the board 14 are respectively inserted into the plural insertion holes 88A of the reception jig 88. In the state in which the board 14 has been set in the reception jig 88, the lower face of the plate shaped section 14A (the face of the board 14 constituting the bottom faces of the plural heat dissipation sections 14B) contacts the upper face of the reception jig 88. This thereby enables the bottom faces of the plural heat dissipation sections 14B of the board 14 to be supported by the upper face of the reception jig 88. As a result thereof, pressure application can be performed at the fixing locations of the circuit parts 18 even when employing the metal board 14 including the plural heat dissipation sections 14B formed with protruding profiles.

Moreover, the present exemplary embodiment is configured such that the pressure concentration section 86 of the upper mold 86 concentrates pressing at the portion where the circuit parts 18 are set. This thereby enables the portions where the circuit parts 18 have been set to be pressed in a pinpoint manner.

Moreover, the present exemplary embodiment is configured such that the pressure concentration section 86 of the upper mold 86 presses the portions where the circuit parts 18 are set through the piece of cardboard 64 and the urethane sheet 104. When the urethane sheet 104 has been pressed toward the board 14 side through the piece of cardboard 64, part of the urethane sheet 104 contacts the insulation layer 16 and also presses the insulation layer 16 downward. This thereby enables locations of the insulation layer 16 where the circuit parts 18 have not been fixed to be suppressed from rising up. Note that due to hardening of the insulation layer 16 being substantially finished through the processes of the first pressing unit 26, any rising up of the insulation layer 16 in the present process is minimal. Moreover, in the present exemplary embodiment, adhesive overhanging from between the insulation layer 16 and the circuit parts 18 can be absorbed in the urethane sheet 104. This thereby enables adhesive overhanging from between the insulation layer 16 and the circuit parts 18 to be suppressed from remaining on the insulation layer 16. Moreover, in the present exemplary embodiment, good shape conforming characteristics can be achieved in the urethane sheet 104 when the urethane sheet 104 has been compressed due to employing the urethane sheet 104 including the open cells or semi-open cells. This means that the urethane sheet 104 deforms to a shape conforming to the outer peripheral face of the circuit parts 18 when the urethane sheet 104 has been compressed, and as a result thereof, the circuit parts 18 can be suppressed from being pressed excessively. Note that a state of the urethane sheet 104 becomes tightly compressed after being subjected to the processes by the second pressing unit 42, and so does not have rebound properties.

Moreover, in the present exemplary embodiment, the air from inside the sealed space 94 formed between the upper mold 86 and the lower mold 84 can be suctioned out by the air suction unit 76. This thereby enables a vacuum to be created at the periphery of the fixing locations of the circuit parts 18 faster than configurations in which the air in a space outside the lower mold 84 and the upper mold 86 is also suctioned in order to suction out the air from inside the sealed space 94 formed between the upper mold 86 and the lower mold 84.

Moreover, in the present exemplary embodiment, the board 14 and the like are heated by the processes of the second preheating unit 40. This thereby enables the time for heating the board 14 and the like in the processes of the second pressing unit 42 to be shortened.

Note that all the processes by the second pressing unit 42 described above may be performed automatically, or some of the processes of the second pressing unit 42 may be performed manually.

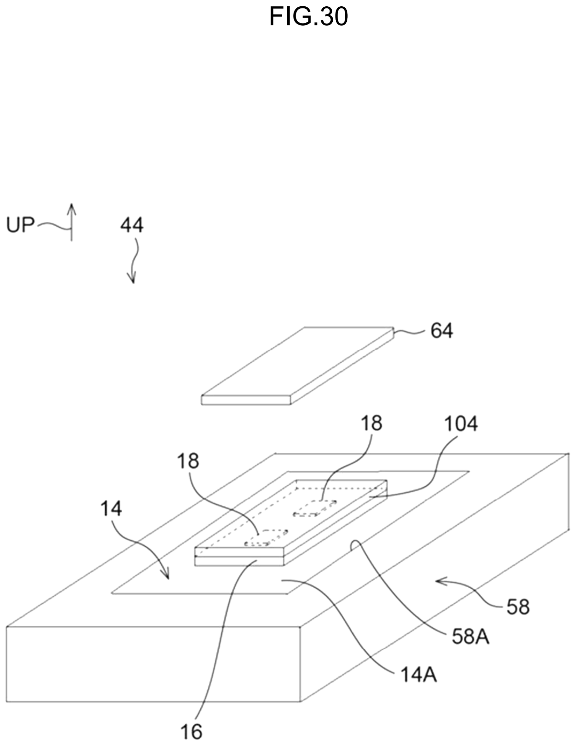

As illustrated in Fig. 4 and Fig. 30, the piece of cardboard 64 that has been set on the urethane sheet 104 is demounted in the second demount unit 44. Note that all the processes of the second demount unit 44 may be performed automatically, or some or all of the processes of the second demount unit 44 may be performed manually.

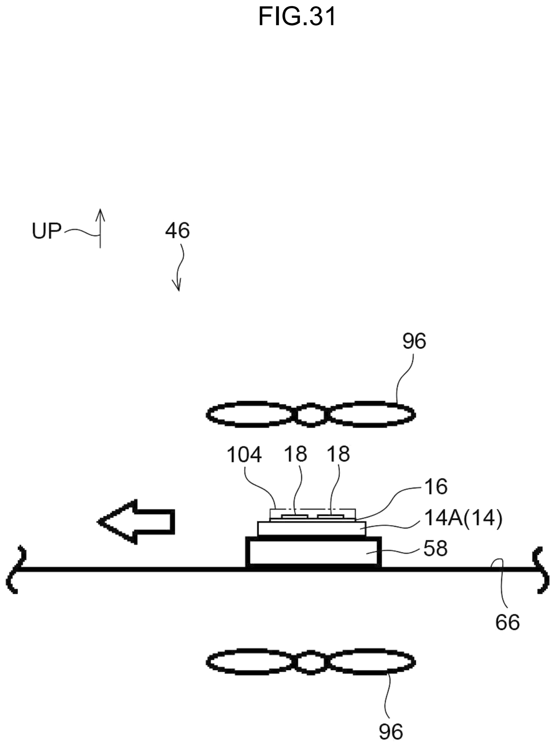

As illustrated in Fig. 4 and Fig. 31, the board 14, the insulation layer 16, and the circuit parts 18 are cooled in the second cooling unit 46. As illustrated in Fig. 31, in the processes of the second cooling unit 46, the common conveyance jig 58 passes through between the upper and lower fans 96 by the common conveyance jig 58 being conveyed by the conveyance unit 66. The board 14 that has been set on the common conveyance jig 58, the insulation layer 16 that has been fixed onto the board 14, and the circuit parts 18 that have been fixed onto the insulation layer 16, are cooled thereby.

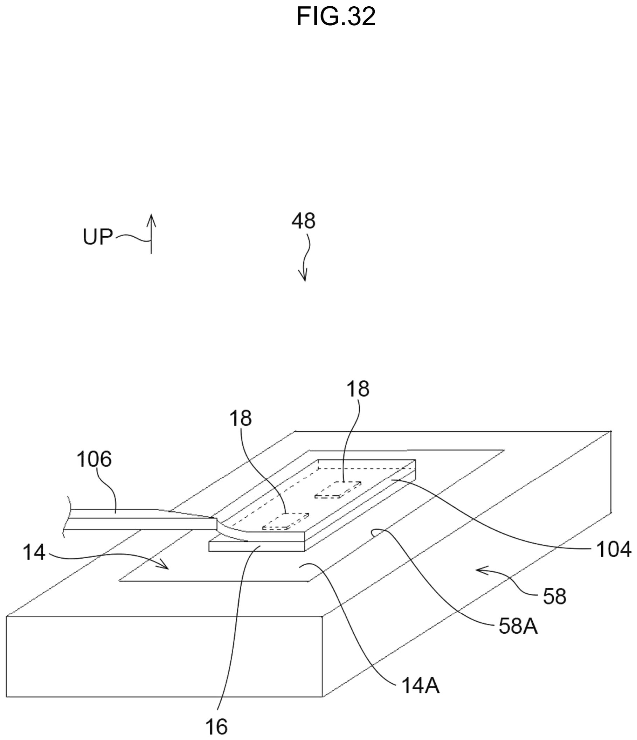

As illustrated in Fig. 4 and Fig. 32, the urethane sheet 104 is removed in the second stripping unit 48 serving as a stripping unit. As illustrated in Fig. 32, the second stripping unit 48 includes a gripper section 106 for gripping the urethane sheet 104. In the processes of the second stripping unit 48, firstly the gripper section 106 grips an end portion of the urethane sheet 104. Next, the gripper section 106 is moved with the end portion of the urethane sheet 104 in a gripped state. The urethane sheet 104 is thereby stripped from the circuit parts 18 and the insulation layer 16 (stripping process). Note that the urethane sheet 104 that has been stripped from the circuit parts 18 and the insulation layer 16 is carried by the gripper section 106 and thrown away into a specific container. The present exemplary embodiment employs the urethane sheet 104 that includes open cells or semi-open cells, thereby facilitating stripping of a sheet shaped member (the urethane sheet 104) compared, for example, to a configuration in which a sheet shaped member formed from rubbery elastomeric material is employed.

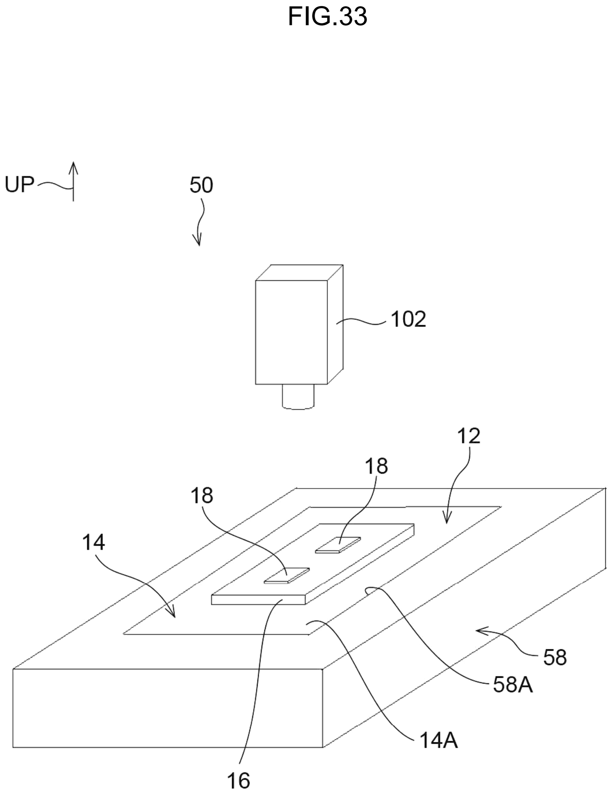

As illustrated in Fig. 4 and Fig. 33, in the second inspection unit 50, inspection is performed as to whether or not the circuit parts 18 are fixed to predetermined positions on the board 14. As illustrated in Fig. 33, in the processes of the second inspection unit 50, inspection is performed as to whether or not the circuit parts 18 are fixed to predetermined positions on the board 14 by comparing inspection data with an image of the board 14, the insulation layer 16, and the circuit parts 18 captured by the camera 102. In cases in which the output inspection result is that the circuit parts 18 are fixed to the predetermined positions on the board 14, the board 14 having the circuit parts 18 fixed onto the insulation layer 16 (the circuit board 12) is shipped as a product. On the other hand, in cases in which the output inspection result is that the circuit parts 18 are not fixed to the predetermined positions on the board 14, the board 14 having the circuit parts 18 fixed to the insulation layer 16 (the circuit board 12) is discarded and not shipped as a product. Note that all the processes by the second inspection unit 50 may be performed automatically, or some or all of the processes of the second inspection unit 50 may be performed manually.

The circuit board 12 illustrated in Fig. 1 and Fig. 2 is manufactured through the respective processes described above.

Note that details regarding the manufacturing device 10 and the respective processes that have been described above may be changed depending on the configuration of the circuit board 12.

Moreover, the insulation layer cutting unit 20, the first setting unit 22, the first preheating unit 24, the first pressing unit 26, the first demount unit 28, the first cooling unit 30, the first stripping unit 32, and the first inspection unit 34 illustrated in Fig. 3, and the circuit part sticking unit 36, the second setting unit 38, the second preheating unit 40, the second pressing unit 42, the second demount unit 44, the second cooling unit 46, the second stripping unit 48, and the second inspection unit 50 illustrated in Fig. 4, may be common equipment, or each may be equipment provided independently.

### Second Exemplary Embodiment

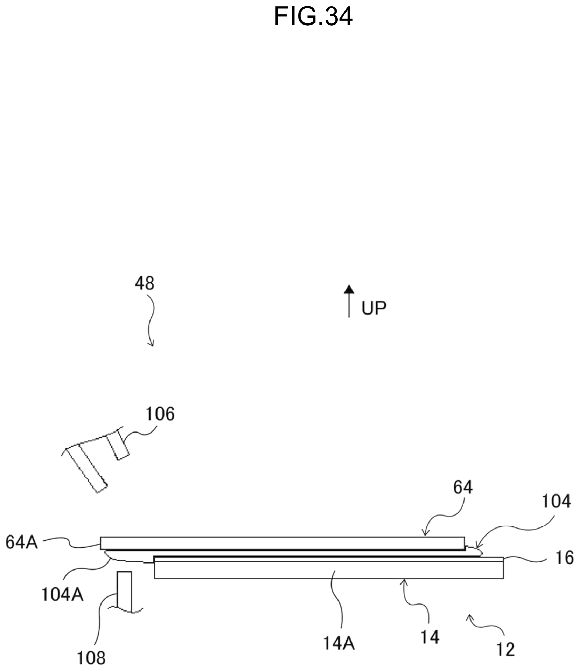

Next, description follows regarding a second stripping unit 48 of a circuit board manufacturing device according to a second exemplary embodiment of the present disclosure, with reference to Fig. 34 to Fig. 37. Note that in the following description, sometimes description will be omitted of members and parts corresponding to the circuit board 12 and the circuit board manufacturing device 10 already explained.

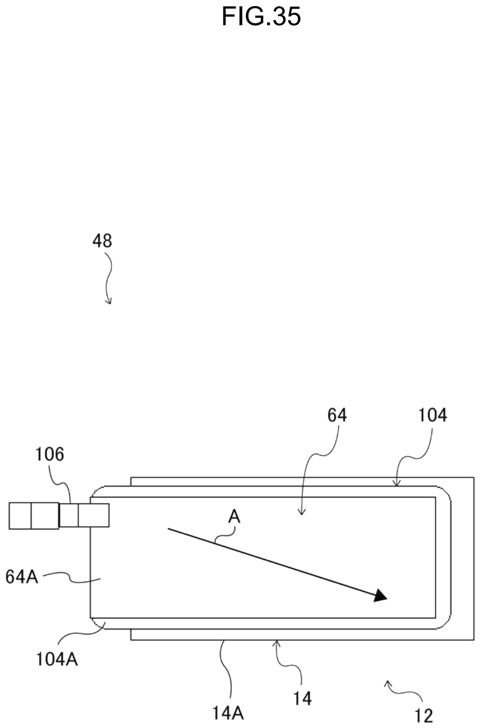

As illustrated in Fig. 34 and Fig. 35, the second stripping unit 48 of the present exemplary embodiment features the inclusion of a push-up section 108 in addition to the gripper section 106. The push-up section 108 is, as an example, formed in a circular pillar shape having an axial direction along the up-down direction, and is supported so as to be able to move in the up-down direction. The push-up section 108 is configured so as to be moved in the up-down direction by motor or magnetic force, compressed air, or the like.

Moreover, a circuit board manufacturing method employing the second stripping unit 48 of the present exemplary embodiment is configured such that, in a state in which the circuit parts 18 fixed to the urethane sheet 104 have been set on the insulation layer 16 fixed to the board 14, a one-end portion 104A of the urethane sheet 104, and a one-end portion 64A of the piece of cardboard 64, extend out sideways at a side of the board 14.

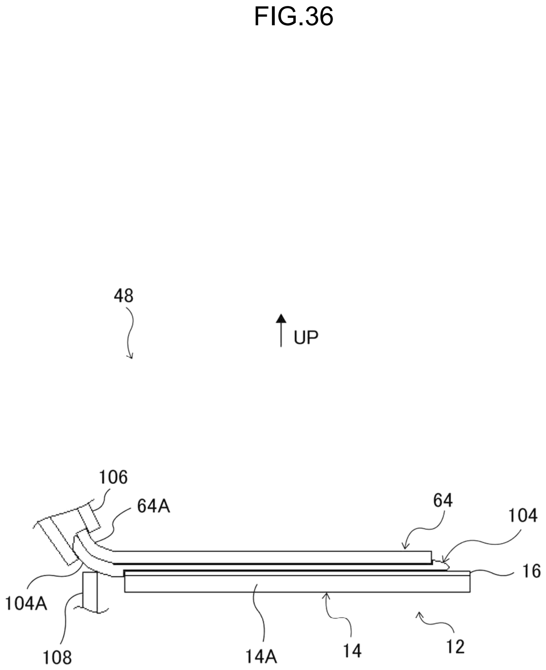

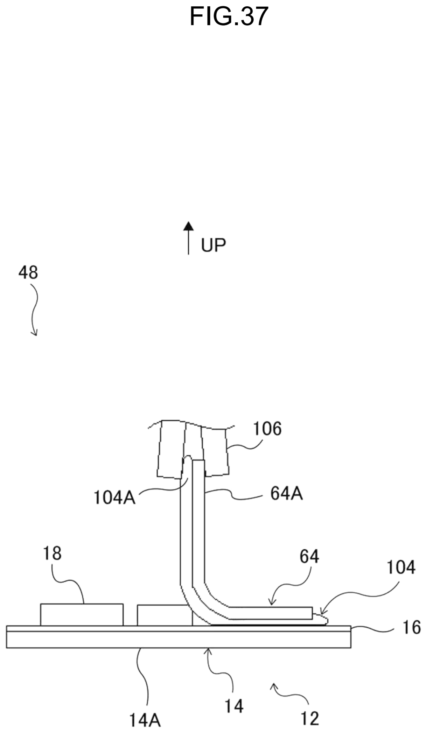

Then, in a stripping process employing the second stripping unit 48 of the present exemplary embodiment, firstly, as illustrated in Fig. 36, by raising the push-up section 108, the one-end portion 104A of the urethane sheet 104 and the one-end portion 64A of the piece of cardboard 64 are pushed upward by the push-up section 108. Next, as illustrated in Fig. 37, by moving the gripper section 106, the urethane sheet 104 is, together with the piece of cardboard 64, removed from on the board 14. Note that the urethane sheet 104 and the piece of cardboard 64 removed from on the board 14 are carried by the gripper section 106 and thrown away into a specific container.

A stripping process employing the second stripping unit 48 of the present exemplary embodiment is configured, as illustrated in Fig. 35, such that corner portions of the urethane sheet 104 and piece of cardboard 64, which are formed in rectangular shapes, are gripped by the gripper section 106. The gripper section 106 is configured to then be moved along a diagonal line of the urethane sheet 104 and the piece of cardboard 64 (the arrow A direction). This means that the urethane sheet 104 and the piece of cardboard 64 can be easily removed from on the board 14.

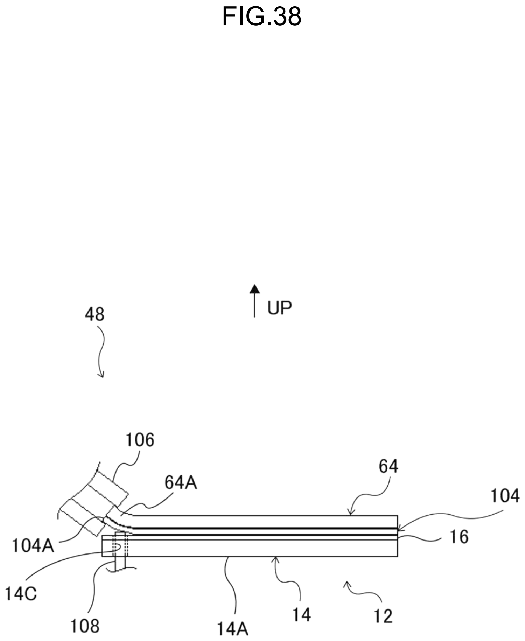

Note that in the present exemplary embodiment an example has been described in which the one-end portion 104A of the urethane sheet 104 and the one-end portion 64A of the piece of cardboard 64 are extended sideways at a side of the board 14 when in a state in which the circuit parts 18 fixed to the urethane sheet 104 have been set on the insulation layer 16 fixed to the board 14, however the present disclosure is not limited thereto. For example, as illustrated in Fig. 38, in cases in which the one-end portion 104A of the urethane sheet 104 and the one-end portion 64A of the piece of cardboard 64 can be pushed up by the push-up section 108 through an opening portion 14C formed in the board 14, the one-end portion 104A of the urethane sheet 104 and the one-end portion 64A of the piece of cardboard 64 may be configured so as not to extend sideways at a side of the board 14.

Although an exemplary embodiment of the present disclosure has been described above, the present disclosure is not limited by the above, and obviously various other modifications may be implemented within a scope not departing from the spirit thereof.

The entire content of the disclosures of Japanese Patent Application No. 2023-001924 filed on January 10, 2023 and Japanese Patent Application No. 2023-122540 filed on July 27, 2023 are incorporated by reference in the present specification.

## Claims

1. A circuit board manufacturing device for a circuit board comprising a board that is formed from a metal material, an insulation layer that is formed in a sheet shape from an insulating material and that is fixed on the board, and a circuit part that is formed from an electroconductive material and that is fixed on the insulation layer, the circuit board manufacturing device comprising:
a pressing unit including a lower mold including a board setting section on which the board is set and an upper mold that is disposed at an upper side with respect to the lower mold and that, when the upper mold engages with the lower mold, presses the circuit part toward a side of the board via a sheet shaped member including open cells or semi-open cells.

2. The circuit board manufacturing device of claim 1, further comprising a stripping unit that is provided on a path for conveying the board from the pressing unit in a state in which the circuit part has been fixed on the insulation layer, and that includes a gripper section that grips the sheet shaped member and removes the sheet shaped member from the board.

3. The circuit board manufacturing device of claim 2, wherein the stripping unit includes a push-up section that pushes up one portion of the sheet shaped member toward a side of the gripper section.

4. A circuit board manufacturing method employing the circuit board manufacturing device of claim 2, the manufacturing method comprising:
a setting process in which the board is set in the board setting section in a state in which the circuit part has been set on the insulation layer; and
a pressure application process in which the circuit part is fixed to the insulation layer by engaging the upper mold with the lower mold and pressing the circuit part toward a side of the board via the sheet shaped member.

5. The circuit board manufacturing method of claim 4, further comprising:
a removal process in which the upper mold is separated from the lower mold, and the board is removed from the board setting section in a state in which the circuit part has been fixed on the insulation layer; and
a stripping process in which the sheet shaped member is gripped by the gripper section and removed from the board.

6. The circuit board manufacturing method of claim 4, wherein:
the circuit board manufacturing device of claim 3 is employed; and
in the stripping process, one portion of the sheet shaped member is pushed up toward the gripper section side by the push-up section.

7. The circuit board manufacturing method of claim 4, wherein, in the pressure application process, adhesive overhanging from between the circuit part and the insulation layer is absorbed at the sheet shaped member.

8. The circuit board manufacturing method of claim 4, further comprising a circuit part setting process that is performed prior to the pressure application process, and in which the circuit part is affixed to the sheet shaped member, and the circuit part, together with the sheet shaped member, is set on the insulation layer.
